# EUROPEAN PATENT APPLICATION

(11) **EP 4 760 686 A1**
(43) Date of publication of application: **17.06.2026**
(21) Application number: 25212895.4
(22) Date of filing: 03.11.2025
(51) Int. Cl.: G09G 3/32

(54) **DISPLAY DEVICE AND ELECTRONIC DEVICE COMPRISING THE SAME**

(30) Priority: 12.12.2024 KR 20240184597
(71) Applicant: Samsung Display Co., Ltd., Yongin-si, Gyeonggi-do 17113 (KR)
(72) Inventor: Hwang, Do Yeon, Yongin-si, Gyeonggi-Do (KR); Bang, Hyun Chol, Yongin-si, Gyeonggi-Do (KR); Choi, Jae Ho, Yongin-si, Gyeonggi-do (KR); Park, No Kyung, Yongin-si, Gyeonggi-Do (KR); Pyo, Ki Hyun, Yongin-si, Gyeonggi-Do (KR)
(74) Representative: Gulde & Partner

(57) **Abstract**

A display device (10) includes: a plurality of subpixels (SP11, SP12, SP13, SP21, SP22, SP23); a plurality of data lines (DL11, DL12, DL13, DL21, DL22, DL23) electrically connected to the plurality of subpixels (SP11, SP12, SP13, SP21, SP22, SP23); a plurality of data pads (DP1, DP2, DP3) electrically connected to the plurality of data lines (DL11, DL12, DL13, DL21, DL22, DL23); a plurality of test pads (TP1, TP2) including a first test pad (TP1) and a second test pad (TP2), the first test pad (TP1) and the second test pad (TP2) being spaced from the plurality of data pads (DP1, DP2, DP3); a first group demux switch element (GDEMT1) connecting a first group data line of the plurality of data lines (DL11, DL12, DL13, DL21, DL22, DL23) to the plurality of data pads (DP1, DP2, DP3); a second group demux switch element (GDEMT2) connecting a second group data line of the plurality of data lines (DL11, DL12, DL13, DL21, DL22, DL23) to the plurality of data pads (DP1, DP2, DP3); and a first test switch element (TET1) located between a first electrode (DEMSD111) of any one of first demux switch elements (DEMT1) included in the first group demux switch element (GDEMT1) and the first test pad (TP1).

## Description

### BACKGROUND

### 1. Field

Aspects of embodiments of the present disclosure relate to a display device, and an electronic device including the display device.

### 2. Description of the Related Art

With the advancement of the information age, the demand for a display device for displaying an image has increased in various forms. For example, the display device has been applied to various electronic devices, such as a smart phone, a digital camera, a laptop computer, a navigator, and a smart television.

The display device includes a light receiving display device, such as a liquid crystal display device, a field emission display device, and a light emitting display device, and an organic light emitting display device including an organic light emitting element, an inorganic light emitting display device including an inorganic light emitting element such as an inorganic semiconductor, and a micro-light emitting display device including a micro-light emitting element.

### SUMMARY

Embodiments of the present disclosure may be directed to a display device capable of testing a data voltage output from a demux switch element.

However, the present disclosure is not limited thereto, and the above and additional aspects and features will be set forth, in part, in the description that follows, and in part, may be apparent from the description, or may be learned by practicing one or more of the presented embodiments of the present disclosure.

The invention is defined by the appended set of claims. The description that follows is subjected to this limitation. Any disclosure lying outside the scope of said claims is only intended for illustrative as well as comparative purposes.

According to one or more embodiments of the present disclosure, a display device is provided that includes an integrated test circuit for measuring data voltages at the output of a demultiplexer. The display device comprises a plurality of subpixels, data lines, and data pads. A first group demux switch element and a second group demux switch element connect the data lines to the data pads. The test circuit includes a plurality of test pads, spaced from the data pads, and a first test switch element. The first test switch element is located between a first test pad and a first electrode of a selected one of a plurality of first demux switch elements, such that other first demux switch elements are electrically separated from the first test switch element.

In an embodiment, the test circuit may be expanded to include a second test switch element located between a second test pad and a first electrode of a selected one of a plurality of second demux switch elements. To protect the test circuit, a resistor may be connected to the gate electrodes of the test switch elements, and an electrostatic discharge circuit may be electrically connected to the various pads. In certain embodiments, the demux switch elements may comprise a plurality of transistors connected in parallel to handle larger currents, and the test switch elements may comprise a plurality of transistors connected in series to improve high-voltage performance.

According to one or more embodiments of the present disclosure, a display device includes: a plurality of subpixels; a plurality of data lines electrically connected to the plurality of subpixels; a plurality of data pads electrically connected to the plurality of data lines; a plurality of test pads including a first test pad and a second test pad, the first test pad and the second test pad being spaced from the plurality of data pads; a first group demux switch element connecting a first group data line of the plurality of data lines to the plurality of data pads; a second group demux switch element connecting a second group data line of the plurality of data lines to the plurality of data pads; and a first test switch element located between a first electrode of any one of first demux switch elements included in the first group demux switch element and the first test pad.

In an embodiment, other first demux switch elements, except for the any one of the first demux switch elements included in the first group demux switch element, may be electrically separated from the first test switch element.

In an embodiment, the display device may further include a second test switch element located between a first electrode of any one of the second demux switch elements included in the second group demux switch element and the second test pad.

In an embodiment, other second demux switch elements, except for the any one of the second demux switch elements included in the second group demux switch element, may be electrically separated from the second test switch element.

In an embodiment, the display device may further include a resistor connected to a gate electrode of the first test switch element and a gate electrode of the second test switch element.

In an embodiment, the display device may further include an electrostatic discharge circuit electrically connected to the plurality of data pads, the plurality of test pads, and the resistor.

In an embodiment, the first group demux switch element may include a plurality of transistors connected in parallel with each other.

In an embodiment, the second group demux switch element may include a plurality of transistors connected in parallel with each other.

In an embodiment, the first test switch element may include a plurality of transistors connected in series with each other.

In an embodiment, the second test switch element may include a plurality of transistors connected in series with each other.

In an embodiment, the plurality of subpixels may include: a first group subpixel connected to the first group demux switch element through the first group data line; and a second group subpixel connected to the second group demux switch element through the second group data line. Any one of a plurality of first subpixels included in the first group subpixel may implement a first color, and may be connected to the any one of the first demux switch elements, and any one of a plurality of second subpixels included in the second group subpixel may implement the first color, and may be connected to the any one of the second demux switch elements.

In an embodiment, the any one of the plurality of the first subpixels may be connected to the first electrode of the any one of the first demux switch elements, and the any one of the plurality of second subpixels may be connected to the first electrode of the any one of the second demux switch elements.

According to one or more embodiments of the present disclosure, an electronic device includes: a display module configured to display an image; a power supply module configured to supply a power source to the display module; and a processor configured to transmit a data signal and a control signal to the display module. The display module includes: a plurality of subpixels; a plurality of data lines electrically connected to the plurality of subpixels; a plurality of data pads electrically connected to the plurality of data lines; a plurality of test pads including a first test pad and a second test pad, the first test pad and the second test pad being spaced from the plurality of data pads; a first group demux switch element connecting a first group data line of the plurality of data lines to the plurality of data pads; a second group demux switch element connecting a second group data line of the plurality of data lines to the plurality of data pads; and a first test switch element located between a first electrode of any one of first demux switch elements included in the first group demux switch element and the first test pad.

In an embodiment, the electronic device may further include a resistance active layer, and the first test switch element may include a first test active layer, and a first test gate electrode located on a gate insulating film covering the first test active layer. The resistance active layer may be electrically connected to a gate electrode of the first test switch element, and the first test active layer may include: a first electrode connected to the first electrode of the any one of the first demux switch elements; a second electrode connected to the first test pad; and a channel located between the first electrode of the first test active layer and the second electrode of the first test active layer.

In an embodiment, the first test active layer and the resistance active layer may be located at a same layer as each other.

In an embodiment, the electronic device may further include a second test switch element located between a first electrode of any one of second demux switch elements included in the second group demux switch element, and the second test switch element may include a second test active layer, and a second test gate electrode located on the gate insulating film covering the second test active layer. The resistance active layer may be electrically connected to a gate electrode of the second test switch element, and the second test active layer may include: a first electrode connected to the first electrode of the any one of the second demux switch elements; a second electrode connected to the second test pad; and a channel located between the first electrode of the second test active layer and the second electrode of the second test active layer.

In an embodiment, a first electrode of the first test switch element may be connected to the first electrode of the any one of the first demux switch elements through a second test connection line, a second electrode of the first test switch element may be connected to the first test pad through a first test connection line, a first electrode of the second test switch element may be connected to the first electrode of the any one of the second demux switch elements through a fourth test connection line, a second electrode of the second test switch element may be connected to the second test pad through a third test connection line, and the second test connection line and the fourth test connection line may be located at a same layer as each other.

In an embodiment, the first test connection line and the third test connection line may be located on different layers from each other.

In an embodiment, the electronic device may further include a first power line configured to be applied with a first power voltage, and the first power line may be spaced from the first test switch element in a plan view.

In an embodiment, the first power line may be spaced from the resistance active layer in a plan view.

In an embodiment, the first power line may overlap with the first group demux switch element and the second group demux switch element in a plan view.

In an embodiment, the electronic device may further include: a first resistance connection electrode connected to the resistance active layer through a plurality of first group resistance contact holes; and a second resistance connection electrode connected to the resistance active layer through a plurality of second group resistance contact holes.

In an embodiment, a number of the plurality of first group resistance contact holes connecting the first resistance connection electrode with the resistance active layer may be same as a number of the plurality of second group resistance contact holes connecting the second resistance connection electrode with the resistance active layer.

In an embodiment, a resistance of the resistance active layer may be 1000Ω or more and 10000Ω or less.

In an embodiment, the plurality of data pads may include a first data pad and a second data pad, and at least one of a plurality of demux connection lines connecting the first data pad to the first group demux switch element may be located on a layer different from that of at least one of a plurality of demux connection lines connecting the second data pad to the first group demux switch element.

According to some embodiments of the present disclosure, in a display device, a first test pad and a second test pad, which are turned on, may be supplied with a data voltage applied to each of a first subpixel for implementing a first color and a second subpixel for implementing a first color. An operator may turn on a test switch element to check whether or not an appropriate data voltage is output to a plurality of subpixels from a first demux switch element and a second demux switch element. In addition, the test switch element may be turned off in a situation in which measurement of the output data voltage is not desired due to reasons such as product shipment. Accordingly, an interference (e.g., an occurrence of a current leakage or a parasitic capacity) with a data line disposed in a direction of a display area may be reduced.

According to some embodiments of the present disclosure, a display device may include an electrostatic discharge circuit connected to output units of a plurality of pads through adjacent lines. Also, the display device may include a resistor connected to a test gate pad. Unlike the resistor, the electrostatic discharge circuit may perform a function of emitting static electricity to the outside of the display device by utilizing a ground or the like. The resistor may protect the display device from static electricity while smoothly turning on/off the test switch elements.

According to some embodiments of the present disclosure, a display device may include a plurality of test switch elements, a plurality of test pads, and a test gate pad to test a data voltage output from a demux switch element. In this case, it may be verified whether or not a first demux switch element for implementing a first color and a second demux switch element for implementing a first color uniformly output a data voltage from a first data pad.

However, the present disclosure is not limited to the above aspects and features, and the above and additional aspects and features will be set forth, in part, in the detailed description that follows with reference to the drawings, and in part, may be apparent therefrom, or may be learned by practicing one or more of the presented embodiments of the present disclosure.

### BRIEF DESCRIPTION OF THE DRAWINGS

The above and other aspects and features of the present disclosure will be more clearly understood from the following detailed description of the illustrative, non-limiting embodiments with reference to the accompanying drawings, in which:
FIG. 1 is a perspective view illustrating a display device according to an embodiment of the present disclosure;
FIG. 2 is a plan view illustrating a display device according to an embodiment of the present disclosure;
FIG. 3 is a circuit diagram illustrating a display device according to an embodiment of the present disclosure;
FIG. 4 is a partially enlarged view illustrating the portion J of FIG. 2;
FIG. 5A is a partially enlarged view illustrating the portion K of FIG. 2;
FIG. 5B is a partially enlarged view illustrating the portion L of FIG. 5A;
FIG. 5C is a partially enlarged view illustrating the portion M of FIG. 5A;
FIG. 5D is a partially enlarged view illustrating the portion N of FIG. 5A;
FIG. 6 is a cross-sectional view taken along the line I-I' of FIG. 5A in a display device according to an embodiment of the present disclosure;
FIG. 7 is a cross-sectional view taken the along line II-II' of FIG. 5A in a display device according to an embodiment of the present disclosure;
FIG. 8 is a cross-sectional view taken along the line III-III' of FIG. 5A in a display device according to an embodiment of the present disclosure;
FIG. 9 is a cross-sectional view taken along the line IV-IV' of FIG. 5A in a display device according to an embodiment of the present disclosure;
FIG. 10 is a cross-sectional view taken along the line II-II' of FIG. 5A in a display device according to an embodiment of the present disclosure;
FIG. 11 is a cross-sectional view taken along the line III-III' of FIG. 5A in a display device according to an embodiment of the present disclosure;
FIG. 12 is a cross-sectional view taken along the line IV-IV' of FIG. 5A in a display device according to an embodiment of the present disclosure;
FIG. 13 is a cross-sectional view taken along the line V-V' of FIG. 5A in a display device according to an embodiment of the present disclosure;
FIG. 14 is a cross-sectional view taken along the line VI-VI' of FIG. 5A in a display device according to an embodiment of the present disclosure;
FIG. 15 is a cross-sectional view taken along the line VII-VII' of FIG. 5A in a display device according to an embodiment of the present disclosure;
FIG. 16 is a block diagram of an electronic device according to an embodiment of the present disclosure; and
FIG. 17 illustrates schematic views of an electronic device according to some embodiments of the present disclosure.

### DETAILED DESCRIPTION

Hereinafter, embodiments will be described in more detail with reference to the accompanying drawings, in which like reference numbers refer to like elements throughout. The present disclosure, however, may be embodied in various different forms, and should not be construed as being limited to only the illustrated embodiments herein. Rather, these embodiments are provided as examples so that this disclosure will be thorough and complete, and will fully convey the aspects and features of the present disclosure to those skilled in the art. Accordingly, processes, elements, and techniques that are not necessary to those having ordinary skill in the art for a complete understanding of the aspects and features of the present disclosure may not be described. Unless otherwise noted, like reference numerals denote like elements throughout the attached drawings and the written description, and thus, redundant description thereof may not be repeated.

When a certain embodiment may be implemented differently, a specific process order may be different from the described order. For example, two consecutively described processes may be performed at the same or substantially at the same time, or may be performed in an order opposite to the described order.

Further, as would be understood by a person having ordinary skill in the art, in view of the present disclosure in its entirety, each suitable feature of the various embodiments of the present disclosure may be combined or combined with each other, partially or entirely, and may be technically interlocked and operated in various suitable ways, and each embodiment may be implemented independently of each other or in conjunction with each other in any suitable manner, unless otherwise stated or implied.

In the drawings, the relative sizes, thicknesses, and ratios of elements, layers, and regions may be exaggerated and/or simplified for clarity. Spatially relative terms, such as "beneath," "below," "lower," "under," "above," "upper," and the like, may be used herein for ease of explanation to describe one element or feature's relationship to another element(s) or feature(s) as illustrated in the figures. It will be understood that the spatially relative terms are intended to encompass different orientations of the device in use or in operation, in addition to the orientation depicted in the figures. For example, if the device in the figures is turned over, elements described as "below" or "beneath" or "under" other elements or features would then be oriented "above" the other elements or features. Thus, the example terms "below" and "under" can encompass both an orientation of above and below. The device may be otherwise oriented (e.g., rotated 90 degrees or at other orientations) and the spatially relative descriptors used herein should be interpreted accordingly.

Further, it should be expected that the shapes shown in the figures may vary in practice depending, for example, on tolerances and/or manufacturing techniques. Accordingly, the embodiments of the present disclosure should not be construed as being limited to the specific shapes shown in the figures, and should be construed considering changes in shapes that may occur, for example, as a result of manufacturing. As such, the shapes shown in the drawings may not depict the actual shapes of areas of the device, and the present disclosure is not limited thereto.

In the figures, the x-axis, the y-axis, and the z-axis are not limited to three axes of the rectangular coordinate system, and may be interpreted in a broader sense. For example, the x-axis, the y-axis, and the z-axis may be perpendicular to or substantially perpendicular to one another, or may represent different directions from each other that are not perpendicular to one another.

It will be understood that, although the terms "first," "second," "third," etc., may be used herein to describe various elements, components, regions, layers and/or sections, these elements, components, regions, layers and/or sections should not be limited by these terms. These terms are used to distinguish one element, component, region, layer or section from another element, component, region, layer or section. Thus, a first element, component, region, layer or section described below could be termed a second element, component, region, layer or section, without departing from the scope of the present disclosure.

It will be understood that when an element or layer is referred to as being "on," "connected to," or "coupled to" another element or layer, it can be directly on, connected to, or coupled to the other element or layer, or one or more intervening elements or layers may be present. Similarly, when a layer, an area, or an element is referred to as being "electrically connected" to another layer, area, or element, it may be directly electrically connected to the other layer, area, or element, and/or may be indirectly electrically connected with one or more intervening layers, areas, or elements therebetween. In addition, it will also be understood that when an element or layer is referred to as being "between" two elements or layers, it can be the only element or layer between the two elements or layers, or one or more intervening elements or layers may also be present.

The terminology used herein is for the purpose of describing particular embodiments and is not intended to be limiting of the present disclosure. As used herein, the singular forms "a" and "an" are intended to include the plural forms as well, unless the context clearly indicates otherwise. It will be further understood that the terms "comprises," "comprising," "includes," "including," "has," "have," and "having," when used in this specification, specify the presence of the stated features, integers, steps, operations, elements, and/or components, but do not preclude the presence or addition of one or more other features, integers, steps, operations, elements, components, and/or groups thereof. As used herein, the term "and/or" includes any and all combinations of one or more of the associated listed items. For example, the expression "A and/or B" denotes A, B, or A and B. Expressions such as "at least one of," when preceding a list of elements, modify the entire list of elements and do not modify the individual elements of the list. For example, the expression "at least one of a, b, or c," "at least one of a, b, and c," and "at least one selected from the group consisting of a, b, and c" indicates only a, only b, only c, both a and b, both a and c, both b and c, all of a, b, and c, or variations thereof.

As used herein, the term "substantially," "about," and similar terms are used as terms of approximation and not as terms of degree, and are intended to account for the inherent variations in measured or calculated values that would be recognized by those of ordinary skill in the art. Further, the use of "may" when describing embodiments of the present disclosure refers to "one or more embodiments of the present disclosure." As used herein, the terms "use," "using," and "used" may be considered synonymous with the terms "utilize," "utilizing," and "utilized," respectively.

Unless otherwise defined, all terms (including technical and scientific terms) used herein have the same meaning as commonly understood by one of ordinary skill in the art to which the present disclosure belongs. It will be further understood that terms, such as those defined in commonly used dictionaries, should be interpreted as having a meaning that is consistent with their meaning in the context of the relevant art and/or the present specification, and should not be interpreted in an idealized or overly formal sense, unless expressly so defined herein.

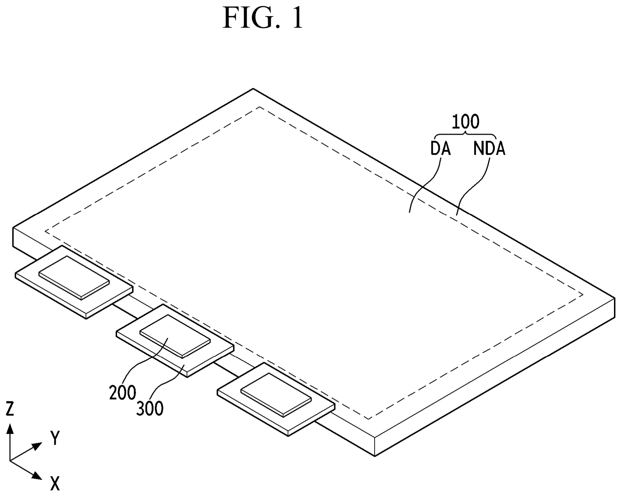

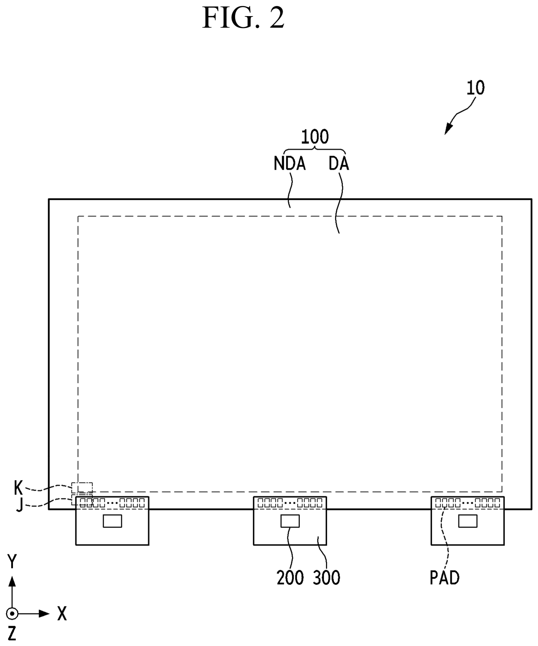

FIG. 1 is a perspective view illustrating a display device according to an embodiment of the present disclosure. FIG. 2 is a plan view illustrating a display device according to an embodiment of the present disclosure.

Referring to FIGS. 1 and 2, a display device 10 is a device that displays a moving image or a still image. The display device 10 may be used as a display screen of various suitable products, such as a television, a laptop computer, a monitor, an advertising board, and a device for the Internet of things (IoT), as well as various suitable portable electronic devices, such as a mobile phone, a smart phone, a tablet personal computer (PC), a smart watch, a watch phone, a mobile communication terminal, an electronic diary, an electronic book, a portable multimedia player (PMP), a navigator, and an ultra mobile PC (UMPC).

The display device 10 may be a light emitting display device, such as an organic light emitting display device using an organic light emitting diode, a quantum dot light emitting display device including a quantum dot light emitting layer, an inorganic light emitting display device including an inorganic semiconductor, and a micro (or nano) light emitting display device using a micro (or nano) light emitting diode (micro LED or nano LED). Hereinafter, for convenience of illustration, the display device 10 may be described in more detail in the context of an organic light emitting display device, but the present disclosure is not limited thereto.

The display device 10 may include a display panel 100, a display driving circuit 200, and a circuit board 300.

The display panel 100 may be formed in a rectangular shaped plane having long sides extending in a first direction (e.g., the X-axis direction) and short sides extending in a second direction (e.g., the Y-axis direction) crossing the first direction. A corner where the long side extending in the first direction (e.g., the X-axis direction) and the short side extending in the second direction (e.g., the Y-axis direction) meet each other may be formed at a right angle, or may be rounded to have a suitable curvature (e.g., a predetermined curvature). However, the planar shape of the display panel 100 is not limited to the rectangular shape, and may be formed in another polygonal shape, a circular shape, or an oval shape. The display panel 100 may be formed to be flat or substantially flat, but the present disclosure is not limited thereto. For example, the display panel 100 may include a curved portion formed at left and right ends or sides, having a constant curvature or a variable curvature. In addition, the display panel 100 may be flexibly formed to be curved, twisted, bent, folded, or rolled.

The display panel 100 may include a display area DA for displaying an image, and a non-display area NDA disposed near (e.g., adjacent to) the display area DA. As another example, the display area DA and the non-display area NDA may be defined in a substrate of the display panel 100.

The display area DA may occupy most of the areas of the display panel 100. The display area DA may be disposed at the center of the display panel 100. Pixels may be disposed in the display area DA to display an image.

The non-display area NDA may be disposed to be adjacent to the display area DA. The non-display area NDA may be an outer area of the display area DA. The non-display area NDA may be disposed to surround (e.g., around a periphery of) the display area DA. The non-display area NDA may be an edge area of the display panel 100.

Pads PAD may be disposed in the non-display area NDA, so that they are electrically connected to the circuit board 300. The pads PAD may be disposed at one edge of the display panel 100. For example, the pads PAD may be disposed at an edge at a lower side of the display panel 100.

The circuit boards 300 may be disposed on the pads PAD disposed at one edge of the display panel 100. The circuit boards 300 may be attached to the pads PAD by using a low resistance and high reliable material, such as an anisotropic conductive film or a self-assembly anisotropic conductive paste (SAP). Therefore, the circuit boards 300 may be electrically connected to signal lines of the display panel 100. The display panel 100 may receive data voltages, power voltages, and scan timing signals through the circuit boards 300. The circuit boards 300 may be flexible printed circuit boards, printed circuit boards, or flexible films, such as chip on films.

The display driving circuits 200 may generate data voltages, power voltages, and scan timing signals. The display driving circuits 200 may supply the data voltages, the power voltages, and the scan timing signals to the display panel 100 through the circuit boards 300.

Each of the display driving circuits 200 may be formed of an integrated circuit (IC) and attached onto the circuit board 300. As another example, the display driving circuits 200 may be attached onto the display panel 100 in a chip on glass (COG) mode, a chip on plastic (COP) mode, or an ultrasonic bonding mode.

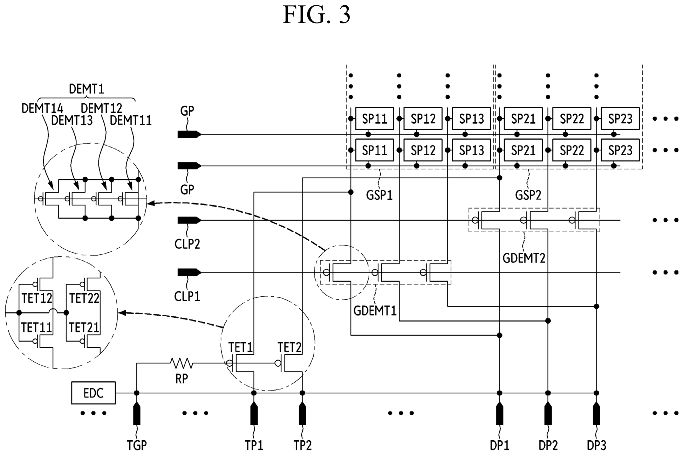

FIG. 3 is a circuit diagram illustrating a display device according to an embodiment of the present disclosure.

Referring to FIG. 3, the display device according to an embodiment of the present disclosure includes a pad, a first group demux switch element GDEMT1, a second group demux switch element GDEMT2, a first test switch element TET1, a second test switch element TET2, a resistor RP, a first group subpixel GSP1, and a second group subpixel GSP2. Hereinafter, the switch element may be described in more detail as a switching thin film transistor (TFT), but the present disclosure is not limited thereto.

The first group subpixel GSP1 and the second group subpixel GSP2 may be disposed in the display area, and the other elements may be disposed in the non-display area except the first group subpixel GSP1 and the second group subpixel GSP2.

The first group subpixel GSP1 may include a plurality of first subpixels SP11, SP12, and SP13. The plurality of first subpixels SP11, SP12, and SP13 may include a first subpixel SP11 for implementing a first color, a second subpixel SP12 for implementing a second color, and a third subpixel SP13 for implementing a third color.

The second group subpixel GSP2 may include a plurality of second subpixels SP21, SP22, and SP23. The plurality of second subpixels SP21, SP22, and SP23 may include a second subpixel SP21 for implementing the first color, a second subpixel SP22 for implementing the second color, and a third subpixel SP23 for implementing the third color.

In the display device according to an embodiment of the present disclosure, the first group subpixel GSP1 and the second group subpixel GSP2 may be repeatedly disposed along a first direction (e.g., a row direction). As shown, the first group subpixel GSP1 and the second group subpixel GSP2 may be sequentially disposed along the first direction, and may be repeatedly disposed along the first direction from the second group subpixel GSP2.

In the first group subpixel GSP1, the first subpixel SP11 for implementing the first color, the second subpixel SP12 for implementing the second color, and the first subpixel SP13 for implementing the third color may be repeatedly disposed in a second direction (e.g., a column direction).

In the second group subpixel GSP2, the second subpixel SP21 for implementing the first color, the second subpixel SP22 for implementing the second color, and the third subpixel SP23 for implementing the third color may be repeatedly disposed in the second direction (e.g., the column direction).

Each of the first color, the second color, and the third color may be any one suitable color selected from the group consisting of red, green, and blue, so as not to overlap one another. For example, the first color may be red, the second color may be green, and the third color may be blue, but the present disclosure is not limited thereto.

The pad may include a plurality of data pads DP1, DP2, and DP3, a plurality of test pads TP1 and TP2, a test gate pad TGP, a plurality of clock pads CLP1 and CLP2, and a plurality of gate pads GP.

The plurality of data pads DP1, DP2, and DP3 may supply data voltages to the first group subpixel GSP1 and the second group subpixel GSP2. The plurality of data pads DP1, DP2, and DP3 may include a first data pad DP1, a second data pad DP2, and a third data pad DP3.

The data voltages supplied from the first data pad DP1, the second data pad DP2, and the third data pad DP3 may be applied to the plurality of first subpixels SP11, SP12, and SP13 disposed in the first group subpixel GSP1 and the plurality of second subpixels SP21, SP22, and SP23 disposed in the second group subpixel GSP2, respectively.

For example, the data voltage supplied from the first data pad DP1 may be applied to the first subpixel SP11 for implementing the first color and the second subpixel SP21 for implementing the first color. The data voltage supplied from the second data pad DP2 may be applied to the first subpixel SP12 for implementing the second color and the second subpixel SP22 for implementing the second color. The data voltage supplied from the third data pad DP3 may be applied to the first subpixel SP13 for implementing the third color and the second subpixel SP23 for implementing the third color. However, the present disclosure is not limited to the above examples.

The first group demux switch element GDEMT1 may include a plurality of first demux switch elements, and the second group demux switch element GDEMT2 may include a plurality of second demux switch elements.

A gate electrode of the first group demux switch element GDEMT1 may be connected to the first clock pad CLP1. First electrodes of the plurality of first demux switch elements included in the first group demux switch element GDEMT1 may be connected to the first subpixel SP11 for implementing the first color, the first subpixel SP12 for implementing the second color, and the first subpixel SP13 for implementing the third color, respectively. Second electrodes of the plurality of first demux switch elements included in the first group demux switch element GDEMT1 may be connected to the first data pad DP1, the second data pad DP2, and the third data pad DP3, respectively. The first group demux switch element GDEMT1 may be turned on by a signal applied through the first clock pad CLP1 to apply the data signals transmitted from the first data pad DP1, the second data pad DP2, and the third data pad DP3 to the first subpixel SP11 for implementing the first color, the first subpixel SP12 for implementing the second color, and the first subpixel SP13 for implementing the third color, respectively.

A gate electrode of the second group demux switch element GDEMT2 may be connected to the second clock pad CLP2. First electrodes of the plurality of second demux switch elements included in the second group demux switch element GDEMT2 may be connected to the second subpixel SP21 for implementing the first color, the second subpixel SP22 for implementing the second color, and the second subpixel SP23 for implementing the third color, respectively. Second electrodes of the plurality of second demux switch elements included in the second group demux switch element GDEMT2 may be connected to the first data pad DP1, the second data pad DP2, and the third data pad DP3, respectively. The second group demux switch element GDEMT2 may be turned on by a signal applied through the second clock pad CLP1 to apply the data signals transmitted from the first data pad DP1, the second data pad DP2, and the third data pad DP3 to the second subpixel SP21 for implementing the first color, the second subpixel SP22 for implementing the second color, and the second subpixel SP23 for implementing the third color, respectively.

The first data pad DP1 may be connected to the first subpixel SP11 for implementing the first color and the second subpixel SP21 for implementing the first color. A first demux switch element DEMT1 for implementing the first color may be disposed between the first subpixel SP11 for implementing the first color and the first data pad DP1. A second demux switch element for implementing the first color may be disposed between the second subpixel SP21 for implementing the first color and the first data pad DP1.

The second data pad DP2 may be connected to the first subpixel SP12 for implementing the second color and the second subpixel SP22 for implementing the second color. A first demux switch element for implementing the second color may be disposed between the first subpixel SP12 for implementing the second color and the second data pad DP2. A second demux switch element for implementing the second color may be disposed between the second subpixel SP22 for implementing the second color and the second data pad DP2.

The third data pad DP3 may be connected to the first subpixel SP13 for implementing the third color and the second subpixel SP23 for implementing the third color. A first demux switch element for implementing the third color may be disposed between the first subpixel SP13 for implementing the third color and the third data pad DP3. A second demux switch element for implementing the third color may be disposed between the second subpixel SP23 for implementing the third color and the third data pad DP3.

Each of the first demux switch element and the second demux switch element, which implement one of the first color, the second color, or the third color, may include a plurality of sub demux switch elements DEMT11, DEMT12, DEMT13, and DEMT14 connected in parallel with one another. For example, referring to an enlarged view if the first demux switch element DEMT1 in FIG. 3, the first demux switch element DEMT1 for implementing the first color may include a first sub demux switch element DEMT11, a second sub demux switch element DEMT12, a third sub demux switch element DEMT13, and a fourth sub demux switch element DEMT14. First electrodes of the sub demux switch elements may be connected to the same node as each other, and second electrodes thereof may be connected to the same node as each other. Because the first demux switch element DEMT1 includes a plurality of sub demux switch elements DEMT11, DEMT12, DEMT13, and DEMT14 connected in parallel, a relatively larger current may be processed, and a power consumption of the display device may be reduced.

As described above, the first electrode of a selected one of the first demux switch elements, namely the first demux switch element DEMT1 for implementing the first color, is connected to the first subpixel SP11 for implementing the first color. In addition, the first electrode of this selected first demux switch element DEMT1 is also connected to the first test pad TP1 via the first test switch element TET1. The first electrode of the first demux switch element DEMT1 for implementing the first color may be connected not only to the first subpixel SP11 for implementing the first color, but also to the first test pad TP1. The first test switch element TET1 is disposed between the first electrode of the first demux switch element DEMT1 for implementing the first color and the first test pad TP1. A gate electrode of the first test switch element TET1 may be connected to the test gate pad TGP. A first electrode of the first test switch element TET1 may be connected to the first electrode of the first demux switch element DEMT1 for implementing the first color. A second electrode of the first test switch element TET1 may be connected to the first test pad TP1.

As described above, a first connection electrode of the second demux switch element for implementing the first color may be connected to the second subpixel SP21 for implementing the first color. The fist connection electrode throughout the description may also be called "first electrode". In addition, the first connection electrode of the second demux switch element for implementing the first color may be also connected to the second test pad TP2. The first connection electrode of the second demux switch element for implementing the first color may be connected not only to the second subpixel SP21 for implementing the first color, but also to the second test pad TP2. The second test switch element TET2 may be disposed between the first connection electrode of the second demux switch element for implementing the first color and the second test pad TP2. A gate electrode of the second test switch element TET2 may be connected to the test gate pad TGP. A first electrode of the second test switch element TET2 may be connected to the first connection electrode of the second demux switch element for implementing the first color. A second electrode of the second test switch element TET2 may be connected to the second test pad TP2.

The gate electrode of the first test switch element TET1 and the gate electrode of the second test switch element TET2 may be connected to the test gate pad TGP. The first test switch element TET1 and the second test switch element TET2 may be turned on by a signal applied through the test gate pad TGP. The turned-on first and second test pads TET1 and TET2 may be supplied with a data voltage applied to each of the first subpixel SP11 for implementing the first color and the second subpixel SP21 for implementing the first color. An operator may turn on the test switch elements TET1 and TET2 to check whether or not an appropriate data voltage is output to the plurality of subpixels from the first demux switch element and the second demux switch element. In addition, the test switch element may be turned off in a situation in which a measurement of the output data voltage is not desired due to reasons such as a product shipment. Accordingly, an interference (e.g., an occurrence of a current leakage or a parasitic capacity) with the data line disposed in a direction of the display area may be reduced.

Each of the first test switch element TET1 and the second test switch element TET2 may include a plurality of sub test switch elements TET11, TET12, TET21, and TET22 connected in series.

For example, referring to an enlarged view of FIG. 3, the first test switch element TET1 may include a first sub test switch element (e.g., an 11th test switch element) TET11 and a second sub test switch element (e.g., a 12th test switch element) TET12. A first electrode of the first sub test switch element TET11 may be connected to a second electrode of the second sub test switch element TET12. A second electrode of the first sub test switch element TET11 may be connected to the first test pad TP1. A first electrode of the second sub test switch element TET12 may be connected to the first electrode of the first demux switch element DEMT1. As the first test switch element includes the sub test switch elements connected in series, processing of a high voltage may be more smoothly performed, and overheating of the individual switch element may be prevented or substantially prevented. Therefore, a reliability of the display device may be improved. This series arrangement allows for the distribution of high voltages across multiple transistors, which effectively increases the total breakdown voltage of the switch. This prevents damage to any single switch element when high-voltage test signals are applied, thereby enhancing the durability and operational lifetime of the test circuit.

The second test switch element TET2 may include a third sub test switch element (e.g., a 21st test switch element) TET21 and a fourth sub test switch element (e.g., a 22nd test switch element) TET22. A first electrode of the third sub test switch element TET21 may be connected to a second electrode of the fourth sub test switch element TET22. A second electrode of the third sub test switch element TET21 may be connected to the second test pad TP2. A first electrode of the fourth sub test switch element TET22 may be connected to the first electrode of the second demux switch element.

The display device according to an embodiment may further include the resistor RP disposed between the test gate pad TGP and the first test switch element TET1 (or the second test switch element TET2). The resistor RP may serve to protect the test switch elements TET1 and TET2, which include the first test switch element TET1 and the second test switch element TET2, and the subpixels SP11, SP12, SP13, SP21, SP22, and SP23 disposed in the display area from static electricity that may occur from the test gate pad TGP. This configuration improves the overall reliability and manufacturing yield of the display device by preventing ESD-induced damage to the sensitive transistor gates of the test switch elements during probing operations. The resistor limits the peak discharge current, protecting the gate oxide from dielectric breakdown. In an embodiment, the resistor RP may be 1000Ω or more and 10000Ω or less. When the resistor RP is less than 1000Ω, the display device may not be properly protected from static electricity. When the resistor RP is greater than 10000Ω, the first test switch element TET1 or the second test switch element TET2 may not be properly turned on or off, whereby the test may not be properly performed or an interference may occur. In more detail, the resistor RP may be 2000Ω or more and 80000Ω or less. In more detail, the resistor RP may be 3000Ω or more and 60,000Ω or less. In the above range, while the first test switch element TET1 and the like are smoothly turned on/off, the display device may be appropriately protected from static electricity. In an embodiment, the resistor RP may be omitted as needed or desired.

The display device according to an embodiment of the present disclosure may further include an electrostatic discharge circuit EDC connected to output units of the plurality of pads TGP, TP1, TP2, DP1, DP2, and DP3 through adjacent lines. Unlike the resistor RP, the electrostatic discharge circuit EDC may perform a function of emitting static electricity to the outside of the display device by utilizing a ground or the like. For example, the electrostatic discharge circuit EDC capable of discharging static electricity to an outer portion of the display device may be disposed. The electrostatic discharge circuit EDC may be connected to the plurality of pads, and the resistor RP may be connected to the test gate pad TGP.

The display device according to an embodiment of the present disclosure includes a plurality of test switch elements TET1 and TET2, a plurality of test pads TP1 and TP2, and a test gate pad TGP in order to test the data voltage output from the demux switch element. In this case, it may be verified whether or not the first demux switch element DEMT1 for implementing the first color and the second demux switch element for implementing the first color uniformly or substantially uniformly output the data voltage from the first data pad DP1.

In order to verify the uniformity of the output data voltage, the display device according to an embodiment of the present disclosure connects the first test pad TP1 to any one (e.g., a single) of the first demux switch elements. The first test switch element TET1 may be disposed between the first demux switch element and the first test pad. The first group demux switch element GDEMT1 may include a plurality of first demux switch elements. The plurality of first demux switch elements may include any one (e.g., DEMT1) of the first demux switch elements, which is connected to the first test pad TP1, and another first demux switch elements except the any one (e.g., DEMT1) of the first demux switch elements.

As illustrated, the first demux switch element DEMT1 that is a target of the enlarged view of the first group demux switch elements GDEMT1 may be "any one of the first demux switch elements" described above, and the other first demux switch elements except the "any one of the first demux switch elements" may be electrically separated from the first test pad TP1.

Likewise, in order to verify the uniformity of the output data voltage, the display device according to an embodiment of the present disclosure connects the second test pad TP2 to any one (e.g., a single) of the second demux switch elements. The second test switch element TET2 may be disposed between the second demux switch element and the second test pad. The second group demux switch element GDEMT2 may include a plurality of second demux switch elements. The plurality of second demux switch elements may include any one of the second demux switch elements, which is connected to the second test pad TP2, and another second demux switch elements except the any one of the second demux switch elements. The other second demux switch elements except the any one of the second demux switch elements of the second group demux switch element GDEMT2 may be electrically separated from the second test pad TP2.

In an embodiment, a color (e.g., the first color) implemented by a subpixel (e.g., the first subpixel SP11 for implementing the first color) connected to the first test pad TP1 may be the same as a color (e.g., the first color) implemented by a subpixel (e.g., the second subpixel SP21 for implementing the first color) connected to the second test pad TP2. In addition, the first test switch element TET1 and the second test switch element TET2 may be connected to the same data pad (e.g., the first data pad DP1).

In the display device according to an embodiment of the present disclosure, the plurality of test pads TP1 and TP2 are connected to the first electrode of each of the plurality of demux switch elements (e.g., the first demux switch element DEMT1 for implementing the first color and the second demux switch element for implementing the first color) connected to the same data pad (e.g., the first data pad DP1) as each other. Therefore, it may be checked whether or not the data voltage supplied from the data pad is appropriately applied to the subpixel after the demux switch element.

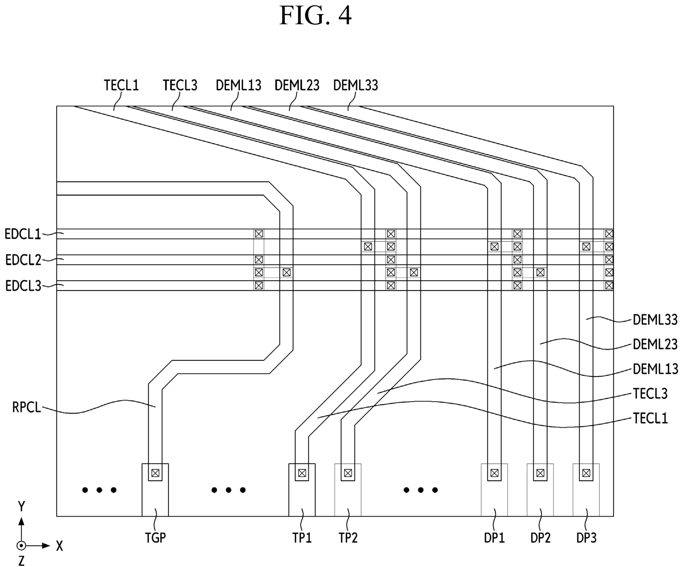

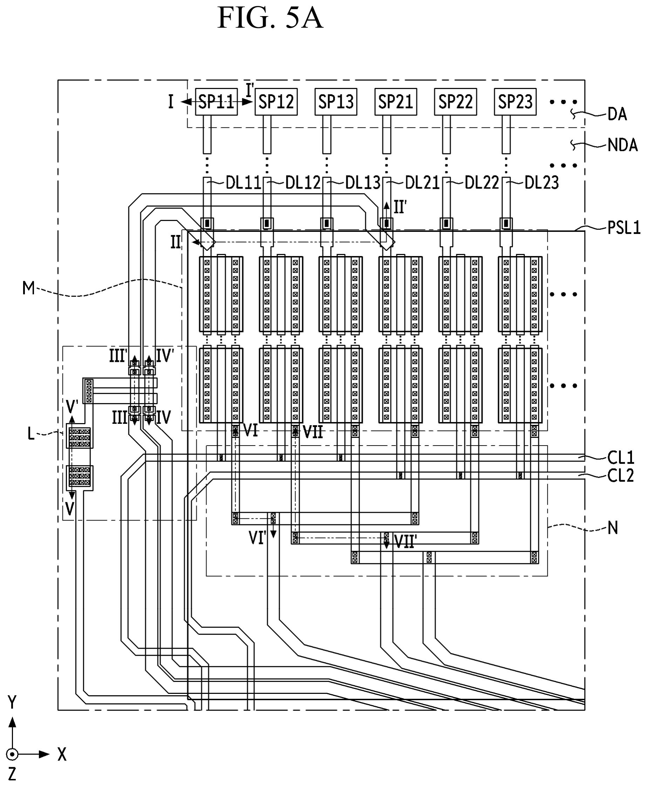

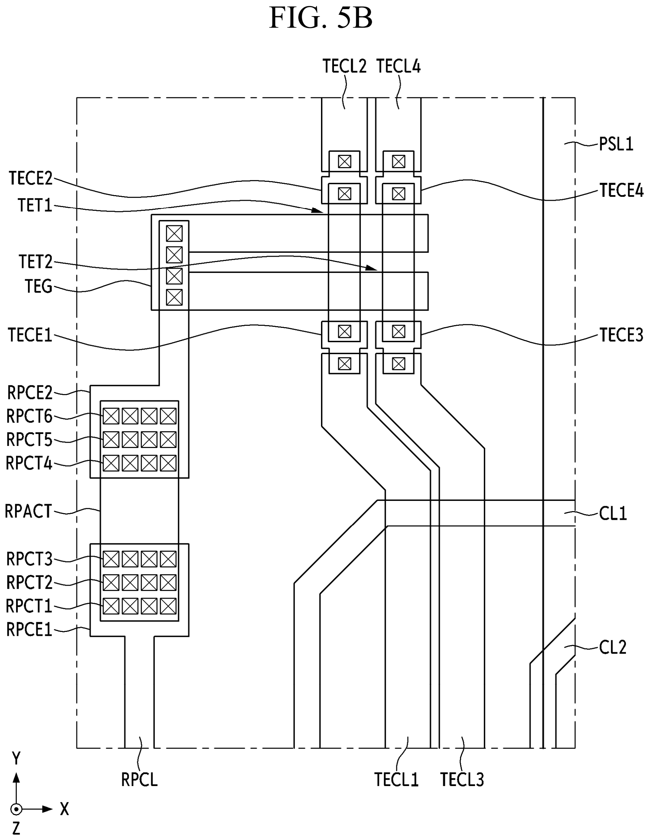

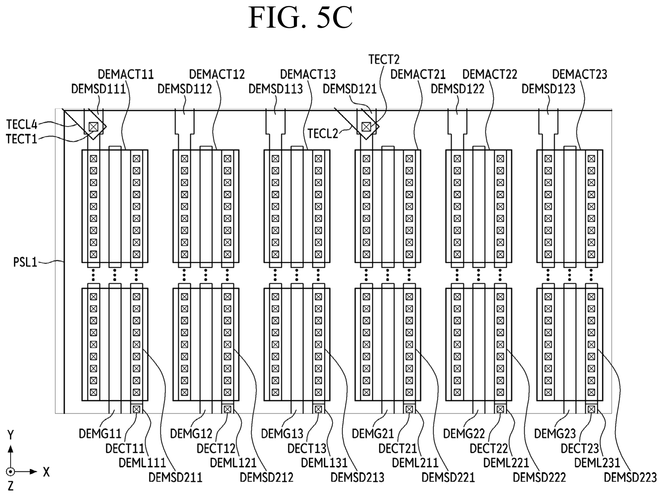

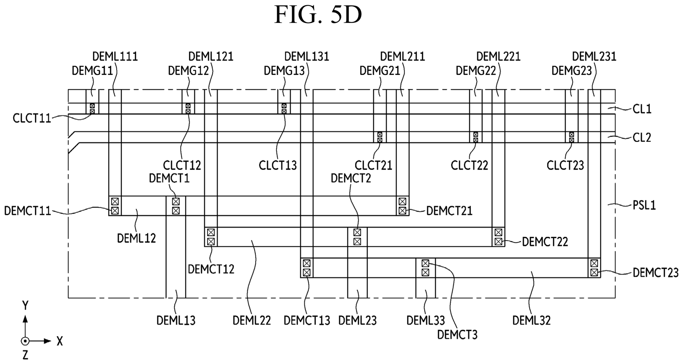

FIG. 4 is a partially enlarged view illustrating the portion J of FIG. 2. FIG. 5A is a partially enlarged view illustrating the portion K of FIG. 2. FIG. 5B is a partially enlarged view illustrating the portion L of FIG. 5A. FIG. 5C is a partially enlarged view illustrating the portion M of FIG. 5A. FIG. 5D is a partially enlarged view illustrating the portion N of FIG. 5A.

Referring to FIGS. 2 and 4, the test gate pad TGP may be connected to a resistance connection line RPCL. The first test pad TP1 may be connected to a first test connection line TECL1, and the second test pad TP2 may be connected to a third test connection line TECL3. The first data pad DP1 may be connected to a 13th demux connection line DEML13, the second data pad DP2 may be connected to a 23rd demux connection line DEML23, and the third data pad DP3 may be connected to a 33rd demux connection line DEML33.

The resistance connection line RPCL, the first test connection line TECL1, a second test connection line TECL2, the 13th demux connection line DEML13, the 23rd demux connection line DEML23 and the 33rd demux connection line DEML33 may all be connected to a line connected to the electrostatic discharge circuit described above through a plurality of contact holes. The line connected to the electrostatic discharge circuit is connected to a plurality of cross lines connecting each other through the contact holes, and the plurality of cross lines are connected again to the resistance connection line RPCL, the first test connection line TECL1, the second test connection line TECL2, the 13th demux connection line DEML13, the 23rd demux connection line DEML23 and the 33rd demux connection line DEML33 through the contact holes, respectively.

Referring to FIGS. 2, 4, and 5A to 5D, the 13th demux connection line DEML13 may be connected to a 12th demux connection line DEML12 through a first demux connection contact hole DEMCT1. The first demux connection contact hole DEMCT1 may be formed as a plurality of first demux connection contact holes. Hereinafter, mention of the plurality of contact holes may be omitted.

The 12th demux connection line DEML12 may be connected to a 111th demux connection line DEML111 through an 11th demux connection contact hole DEMCT11. The 12th demux connection line DEML12 may be connected to a 211th demux connection line DEML211 through a 21st demux connection contact hole DEMCT21.

The 111th demux connection line DEML111 may be connected to a second connection electrode DEMSD211 of the first demux switch element for implementing the first color through an 11th demux contact hole DECT11. The second connection electrode throughout the description may also be called "second electrode".

The second connection electrode DEMSD211 of the first demux switch element for implementing the first color may be connected to an 11th demux active layer DEMACT11 through a contact hole. The 11th demux active layer DEMACT11 constitutes the first demux switch element for implementing the first color together with an 11th demux gate electrode DEMG11. The 11th demux gate electrode DEMG11 may be connected to a first clock line CL1. The 11th demux active layer DEMACT11 may be connected to a first connection electrode DEMSD111 of the first demux switch element for implementing the first color through a contact hole. The first connection electrode DEMSD111 of the first demux switch element for implementing the first color is connected to an 11th data line DL11, and the 11th data line DL11 may apply the data voltage from the first data pad DP1 to the first subpixel SP11 for implementing the first color.

The 211th demux connection line DEML211 may be connected to a second connection electrode DEMSD221 of the second demux switch element for implementing the first color through a 21st demux contact hole DECT21.

The second connection electrode DEMSD221 of the second demux switch element for implementing the first color may be connected to a 21st demux active layer DEMACT21 through a contact hole. The 21st demux active layer DEMACT21 constitutes the second demux switch element for implementing the first color together with a 21st demux gate electrode DEMG21. The 21st demux gate electrode DEMG21 may be connected to a second clock line CL2. The 21st demux active layer DEMACT21 may be connected to a first connection electrode DEMSD121 of the second demux switch element for implementing the first color through a contact hole. The first connection electrode DEMSD121 of the second demux switch element for implementing the first color is connected to a 21st data line DL21, and the 21st data line DL21 may apply the data voltage from the first data pad DP1 to the second subpixel SP21 for implementing the first color.

The 23rd demux connection line DEML23 may be connected to the 22nd demux connection line DEML22 through a second demux connection contact hole DEMCT2.

The 22nd demux connection line DEML22 may be connected to a 121st demux connection line DEML121 through a 12th demux connection contact hole DEMCT12. The 22nd demux connection line DEML22 may be connected to a 221st demux connection line DEML221 through a 22nd demux connection contact hole DEMCT22.

The 121st demux connection line DEML121 may be connected to a second connection electrode DEMSD212 of the first demux switch element for implementing the second color through a 12th demux contact hole DECT12.

The second connection electrode DEMSD212 of the first demux switch element for implementing the second color may be connected to a 12th demux active layer DEMACT12 through a contact hole. The 12th demux active layer DEMACT12 constitutes the first demux switch element for implementing the second color together with the 12th demux gate electrode DEMG12. The 12th demux gate electrode DEMG12 may be connected to the first clock line CL1. The 12th demux active layer DEMACT12 may be connected to a first connection electrode DEMSD112 of the first demux switch element for implementing the second color through the contact hole. The first connection electrode DEMSD112 of the first demux switch element for implementing the second color is connected to a 12th data line DL12, and 12th data line DL12 may apply the data voltage from the second data pad DP2 to the first subpixel SP12 for implementing the second color.

The 221st demux connection line DEML221 may be connected to a second connection electrode DEMSD222 of the second demux switch element for implementing the second color through a 22nd demux contact hole DECT22.

The second connection electrode DEMSD222 of the second demux switch element for implementing the second color may be connected to a 22nd demux active layer DEMACT22 through a contact hole. The 22nd demux active layer DEMACT22 constitutes a second demux switch element for implementing the second color together with a 22nd demux gate electrode DEMG22. The 22nd demux gate electrode DEMG22 may be connected to the second clock line CL2. The 22nd demux active layer DEMACT22 may be connected to a first connection electrode DEMSD122 of the second demux switch element for implementing the second color through a contact hole. The first connection electrode DEMSD122 of the second demux switch element for implementing the second color may be connected to a 22nd data line DL22, and the 22nd data line DL22 may apply the data voltage from the second data pad DP2 to the second subpixel SP22 for implementing the second color.

The 33rd demux connection line DEML33 may be connected to a 32nd demux connection line DEML32 through a third demux connection contact hole DEMCT3.

The 32nd demux connection line DEML32 may be connected to a 131st demux connection line DEML131 through a 13th demux connection contact hole DEMCT13. The 32nd demux connection line DEML32 may be connected to a 231st demux connection line DEML231 through a 23rd demux connection contact hole DEMCT23.

The 131st demux connection line DEML131 may be connected to a second connection electrode DEMSD213 of the first demux switch element for implementing the third color through a 13th demux contact hole DECT13.

The second connection electrode DEMSD213 of the first demux switch element for implementing the third color may be connected to a 13th demux active layer DEMACT13 through a contact hole. The 13th demux active layer DEMACT13 constitutes a first demux switch element for implementing the third color together with a 13th demux gate electrode DEMG13. The 13th demux gate electrode DEMG13 may be connected to the first clock line CL1. The 13th demux active layer DEMACT13 may be connected to a first connection electrode DEMSD113 of the first demux switch element for implementing the third color through a contact hole. The first connection electrode DEMSD113 of the first demux switch element for implementing the third color is connected to a 13th data line DL13, and the 13th data line DL13 may apply the data voltage from the third data pad DP3 to the first subpixel SP13 for implementing the third color.

The 231st demux connection line DEML231 may be connected to a second connection electrode DEMSD223 of the second demux switch element for implementing the third color through a 23rd demux contact hole.

The second connection electrode DEMSD223 of the second demux switch element for implementing the third color may be connected to a 23rd demux active layer DEMACT23 through a contact hole. The 23rd demux active layer DEMACT23 constitutes the second demux switch element for implementing the third color together with a 23rd demux gate electrode DEMG23. The 23rd demux gate electrode DEMG23 may be connected to the second clock line CL2. The 23rd demux active layer DEMACT23 may be connected to a first connection electrode DEMSD123 of the second demux switch element for implementing the third color through the contact hole. The first connection electrode DEMSD123 of the second demux switch element for implementing the third color is connected to a 23rd data line DL23, and the 23rd data line DL23 may apply the data voltage from the third data pad DP3 to the second subpixel SP23 for implementing the third color.

As shown, a first power line PSL1 may overlap with the first group demux switch element, the second group demux switch element, and the plurality of demux connection lines.

The first power line PSL1 may be spaced apart from the first test switch element TET1, the second test switch element TET2, and the resistor. The resistor may include a resistance active layer RPACT.

The first test switch element TET1 may be connected to a first test connection electrode TECE1 and a second test connection electrode TECE2. The second test switch element TET2 may be connected to a third test connection electrode TECE3 and a fourth test connection electrode TECE4.

The first test connection electrode TECE1 may be connected to the first test connection line TECL1. The second test connection electrode TECE2 may be connected to the second test connection line TECL2. The third test connection electrode TECE3 may be connected to the third test connection line TECL3. The fourth test connection electrode TECE4 may be connected to a fourth test connection line TECL4.

The first test connection line TECL1 and the third test connection line TECL3 may be connected to the first test pad TP1 and the second test pad TP2, respectively.

The second test connection line TECL2 and the fourth test connection line TECL4 may be connected to the first demux switch element and the second demux switch element. For example, the second test connection line TECL2 may be connected to the first connection electrode DEMSD121 of the second demux switch element for implementing the first color. The fourth test connection line TECL4 may be connected to the first connection electrode DEMSD111 of the first demux switch element for implementing the first color.

The gate electrode of the first test switch element TET1 and the gate electrode of the second test switch element TET2 may be connected to each other. A test gate electrode TEG may be connected to a second resistance connection electrode RPCE2 through a contact hole.

The second resistance connection electrode RPCE2 may be connected to the resistance active layer RPACT through a contact hole. The resistance active layer RPACT may be connected to a first resistance connection electrode RPCE1 through a contact hole. The first resistance connection electrode RPCE1 may be connected to the resistance connection line RPCL, and the resistance connection line RPCL may be connected to the test gate pad TGP.

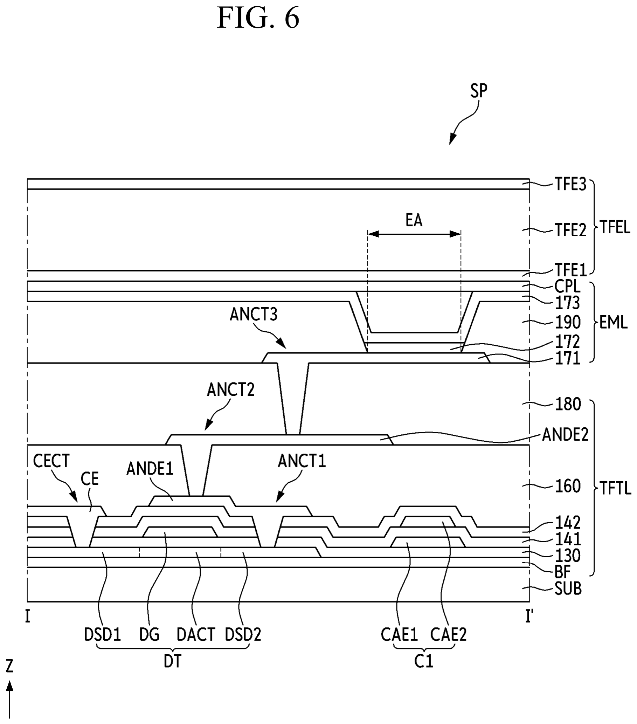

FIG. 6 is a cross-sectional view taken along the line I-I' of FIG. 5A in the display device according to embodiments of the present disclosure.

Referring to FIGS. 5A and 6, the illustrated cross-sectional view may represent that of a subpixel SP according to an embodiment of the present disclosure. Each of the subpixels SP (e.g., SP11, SP12, SP13, SP21, SP22, and SP23) may include at least one display transistor DT, a capacitor C1, and at least one light emitting element 171, 172, and 173.

A substrate SUB may be made of an insulating material, such as a polymer resin and/or glass. For example, the substrate SUB may include polyimide. In this case, the substrate SUB may be a flexible substrate capable of being subjected to bending, folding, and/or rolling.

A thin film transistor layer TFTL, which includes the display transistor DT and the capacitor C1 of each of the subpixels SP, may be disposed on the substrate SUB. The thin film transistor layer TFTL may include the display transistor DT, a first anode connection electrode ANDE1, a second anode connection electrode ANDE2, a buffer film BF, a gate insulating film 130, a first interlayer insulating film 141, a second interlayer insulating film 142, a first planarization layer 160, and a second planarization layer 180.

The buffer film BF may be disposed on the substrate SUB. The buffer film BF may be formed of a silicon nitride layer, a silicon oxynitride layer, a silicon oxide layer, a titanium oxide layer, and/or an aluminum oxide layer.

The display transistor DT may be disposed on the buffer film BF. The display transistor DT may include a display active layer DACT, a display gate electrode DG, a first display electrode (e.g., a first electrode of the display transistor DT) DSD1, and a second display electrode (e.g., a second electrode of the display transistor DT) DSD2.

The display active layer DACT, the first display electrode DSD1, and the second display electrode DSD2 of the display transistor DT may be disposed on the buffer film BF. The display active layer DACT may include a silicon semiconductor, such as polycrystalline silicon, a single crystal silicon, a low-temperature polycrystalline silicon, and/or amorphous silicon. The first display electrode DSD1 and the second display electrode DSD2 may have a conductivity by doping the silicon semiconductor with ions or impurities. The display active layer DACT overlaps with the display gate electrode DG in a third direction (e.g., the Z-axis direction), and the first display electrode DSD1 and the second display electrode DSD2 may not overlap with the display gate electrode DG in the third direction (e.g., the Z-axis direction). The third direction (e.g., the Z-axis direction) may be defined as a thickness direction of the substrate SUB or a thickness direction of the display panel 100. A functional layer, which includes the display active layer DACT, may be disposed between the buffer film BF and the gate insulating film 130.

The gate insulating film 130 may be disposed on the display active layer DACT, the first display electrode DSD1, and the second display electrode DSD2 of the display transistor DT. The gate insulating film 130 may be formed of an inorganic film, for example, such as a silicon nitride layer, a silicon oxynitride layer, a silicon oxide layer, a titanium oxide layer, or an aluminum oxide layer.

The display gate electrode DG of the display transistor DT and a first capacitor electrode CAE1 of the capacitor C1 may be disposed on the gate insulating film 130. The display gate electrode DG may overlap with the display active layer DACT in the third direction (e.g., the Z-axis direction). The first capacitor electrode CAE1 may overlap with a second capacitor electrode CAE2 in the third direction (e.g., the Z-axis direction). Each of the display gate electrode DG and the first capacitor electrode CAE1 may be formed of a single layer or multi-layers made of any one or more of molybdenum (Mo), aluminum (Al), chromium (Cr), gold (Au), titanium (Ti), nickel (Ni), neodymium (Nd) copper (Cu), or a suitable alloy thereof. The first capacitor electrode CAE1 may include the same material as that of the display gate electrode DG. A first gate metal layer, which includes the display gate electrode DG and the first capacitor electrode CAE1, may be disposed between the gate insulating film 130 and the first interlayer insulating film 141.

The first interlayer insulating film 141 may be disposed on the display gate electrode DG and the first capacitor electrode CAE1. The first interlayer insulating film 141 may be formed of an inorganic film, for example, such as a silicon nitride layer, a silicon oxynitride layer, a silicon oxide layer, a titanium oxide layer, or an aluminum oxide layer.

The second capacitor electrode CAE2 may be disposed on the first interlayer insulating film 141. Because the first interlayer insulating film 141 has a suitable dielectric constant (e.g., a predetermined dielectric constant), the capacitor C1 may be formed by the first capacitor electrode CAE1, the second capacitor electrode CAE2, and the first interlayer insulating film 141 disposed between the first capacitor electrode CAE1 and the second capacitor electrode CAE2. The second capacitor electrode CAE2 may be formed of a single layer or multi-layers made of any one or more of molybdenum (Mo), aluminum (Al), chromium (Cr), gold (Au), titanium (Ti), nickel (Ni), neodymium (Nd), copper (Cu), or a suitable alloy thereof. A second gate metal layer, which includes the second capacitor electrode CAE2, may be disposed between the first interlayer insulating film 141 and the second interlayer insulating film 142.

The second interlayer insulating film 142 may be disposed on the second capacitor electrode CAE2. The second interlayer insulating film 142 may be formed of an inorganic film, for example, such as a silicon nitride layer, a silicon oxynitride layer, a silicon oxide layer, a titanium oxide layer, or an aluminum oxide layer.

The first anode connection electrode ANDE1 may be disposed on the second interlayer insulating film 142. The first anode connection electrode ANDE1 may be connected to the second display electrode DSD2 through a first anode contact hole ANCT1 that exposes the second display electrode DSD2 of the display transistor DT by passing through (e.g., penetrating) the first interlayer insulating film 141 and the second interlayer insulating film 142. The first anode connection electrode ANDE1 may be formed of a single layer or multi-layers made of any one or more of molybdenum (Mo), aluminum (Al), chromium (Cr), gold (Au), titanium (Ti), nickel (Ni), neodymium (Nd), copper (CU), or a suitable alloy thereof.

A connection electrode CE may be disposed on the second interlayer insulating film 142. The connection electrode CE may be connected to the first display electrode DSD1 through a connection electrode contact hole CECT that exposes the first display electrode DSD1 of the display transistor DT by passing through (e.g., penetrating) the first interlayer insulating film 141 and the second interlayer insulating film 142. The connection electrode CE may be formed of a single layer or multi-layers made of any one or more of molybdenum (Mo), aluminum (Al), chromium (Cr), gold (Au), titanium (Ti), nickel (Ni), neodymium (Nd), copper (CU), or a suitable alloy thereof. In an embodiment, the connection electrode CE may include the same material as that of the first anode connection electrode ANDE1. A first data metal layer, which includes the first anode connection electrode ANDE1 and the connection electrode CE, may be disposed between the second interlayer insulating film 142 and the first planarization layer 160.

The first planarization layer 160 for planarization may be disposed on the first anode connection electrode ANDE1. The first planarization layer 160 may be formed of an organic layer, such as an acrylic resin, an epoxy resin, a phenolic resin, a polyamide resin, or a polyimide resin.

The second anode connection electrode ANDE2 may be disposed on the first planarization layer 160. The second anode connection electrode ANDE2 may be connected to the first anode connection electrode ANDE1 through a second anode contact hole ANCT2 that exposes the first anode connection electrode ANDE1 by passing through (e.g., penetrating) the first planarization layer 160. The second anode connection electrode ANDE2 may be formed of a single layer or multi-layers made of any one or more of molybdenum (Mo), aluminum (Al), chromium (Cr), gold (Au), titanium (Ti), nickel (Ni), neodymium (Nd), copper (CU), or a suitable alloy thereof. A second data metal layer, which includes the second anode connection electrode ANDE2, may be disposed between the second interlayer insulating film 142 and the first planarization layer 160.

The second planarization layer 180 for planarization may be disposed on the second anode connection electrode ANDE2. The second planarization layer 180 may be formed of an organic layer, such as an acrylic resin, an epoxy resin, a phenolic resin, a polyamide resin, or a polyimide resin.

A light emitting element layer EML may be disposed on the second planarization layer 180. The light emitting element layer EML may include light emitting elements 171, 172, and 173 and a bank 190. Each of the light emitting elements 171, 172, and 173 may include a pixel electrode 171, a light emitting layer 172, and a common electrode 173. The common electrode 173 may be connected in common to a plurality of other light emitting elements 171, 172, and 173.

The pixel electrode 171 may be formed on the second planarization layer 180. The pixel electrode 171 may be connected to the second anode connection electrode ANDE2 through a third anode contact hole ANCT3 that exposes the second anode connection electrode ANDE2 by passing through (e.g., penetrating) the second planarization layer 180.

In a top emission structure in which light is emitted in a direction of the common electrode 173 based on the light emitting layer 172, the pixel electrode 171 may be formed of a metal material having a high reflectance, such as a stacked structure (Ti/Al/Ti) of aluminum and titanium, a stacked structure (ITO/AI/ITO) of indium tin oxide (ITO) and aluminum, an APC alloy, and/or a stacked structure (ITO/APC/ITO) of an APC alloy and ITO. The APC alloy may be an alloy of silver (Ag), palladium (Pd), and copper (Cu).

The bank 190 may be formed to partition the pixel electrode 171 on the first planarization layer 160, thereby defining a light emission area EA. The light emission area EA represents an area in which the pixel electrode 171, the light emitting layer 172, and the common electrode 173 are sequentially stacked to recombine holes from the pixel electrode 171 with electrons from the common electrode 173 in the light emitting layer 172, thereby emitting light. The bank 190 may be formed to cover an edge of the pixel electrode 171. The bank 190 may be formed of an organic layer, such as an acrylic resin, an epoxy resin, a phenolic resin, a polyamide resin, and/or a polyimide resin.

The light emitting layer 172 may be formed on the pixel electrode 171 and the bank 190. The light emitting layer 172 may include an organic material to emit light of a desired color (e.g., a predetermined color). For example, the light emitting layer 172 may include a hole transporting layer, an organic material layer, and an electron transporting layer.

The common electrode 173 may be formed on the light emitting layer 172. The common electrode 173 may be formed to cover the light emitting layer 172. The common electrode 173 may be a common layer commonly formed in all light emission areas EA including the light emission area EA illustrated in FIG. 6. A capping layer CPL may be formed on the common electrode 173.

In the top emission structure, the common electrode 173 may be formed of a transparent conductive material (TCO), such as indium tin oxide (ITO) and/or an indium zinc oxide (IZO), which may transmit light, or a semi-transmissive conductive material, such as magnesium (Mg), silver (Ag), or an alloy of magnesium (Mg) and silver (Ag). When the common electrode 173 is formed of a semi-transmissive metal material, light emission efficiency may be increased by a micro cavity.

An encapsulation layer TFEL may be disposed on the common electrode 173. The encapsulation layer TFEL may include at least one inorganic film to prevent oxygen or moisture from being permeated into the light emitting element layer EML. Also, the encapsulation layer TFEL may include at least one organic film to protect the light emitting element layer EML from particles, such as dust. For example, the encapsulation layer TFEL may include a first inorganic layer TFE1, an organic layer TFE2, and a second inorganic layer TFE3.

The first inorganic layer TFE1 may be disposed on the common electrode 173, the organic layer TFE2 may be disposed on the first inorganic layer TFE1, and the second inorganic layer TFE3 may be disposed on the organic layer TFE2. The first inorganic layer TFE1 and the second inorganic layer TFE3 may be formed of multi-layers in which one or more inorganic films of a silicon nitride layer, a silicon oxynitride layer, a silicon oxide layer, a titanium oxide layer, and/or an aluminum oxide layer are alternately stacked. The organic layer TFE2 may be formed of an acrylic resin, an epoxy resin, a phenolic resin, a polyamide resin, a polyimide resin, and/or the like.

In some embodiments, a filling layer, a sealing material, and an encapsulation substrate may be disposed instead of the encapsulation layer TFEL. In this case, the encapsulation substrate may be an insulating substrate containing an insulating material, such as glass or a plastic. The filling layer may be an air layer in a vacuum state, but the present disclosure is not limited thereto. The sealing material may be disposed in the non-display area of the display panel 100, and may surround (e.g., around a periphery of) the display area DA.

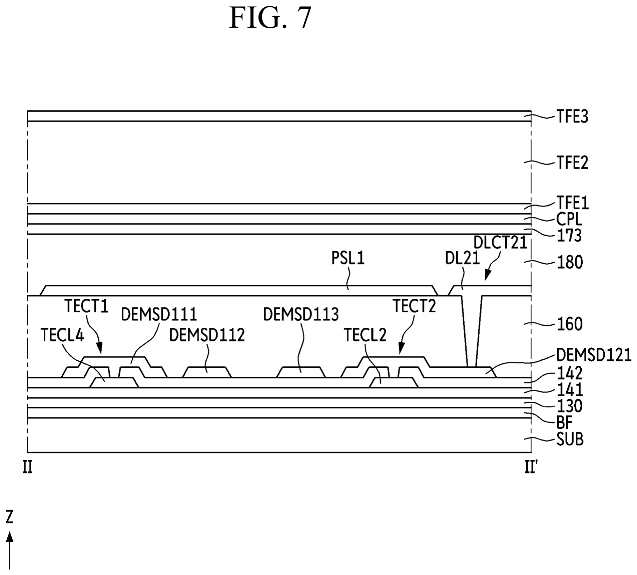

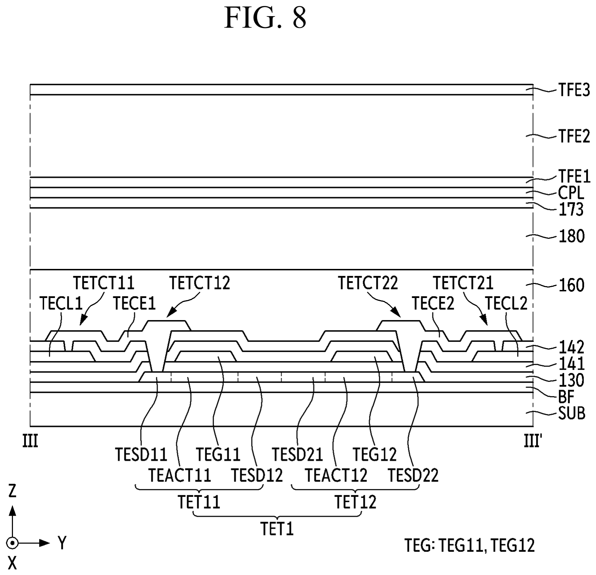

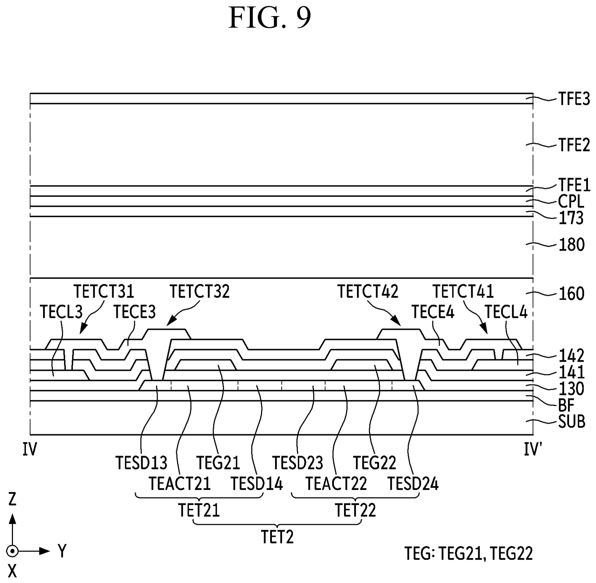

FIG. 7 is a cross-sectional view taken along the line II-II' of FIG. 5A in a display device according to an embodiment of the present disclosure. FIG. 8 is a cross-sectional view taken along the line III-III' of FIG. 5A in a display device according to an embodiment of the present disclosure. FIG. 9 is a cross-sectional view taken along the line IV-IV' of FIG. 5A in a display device according to an embodiment of the present disclosure. In FIGS. 7 to 9, the same reference numerals are used to denote the same or substantially the same elements as those described above, and thus, redundant description thereof may not be repeated hereinafter.

Referring to FIGS. 5A and 7, the second test connection line TECL2 and the fourth test connection line TECL4 may be disposed on the first interlayer insulating film 141. The second gate metal layer, which includes the second test connection line TECL2 and the fourth test connection line TECL4, may be disposed between the first interlayer insulating film 141 and the second interlayer insulating film 142. The second interlayer insulating film 142 may be disposed to cover the second test connection line TECL2 and the fourth test connection line TECL4. The second test connection line TECL2 and the fourth test connection line TECL4 may include the same material as that of the second capacitor electrode CAE2 described above.

A first connection electrode DEMSD111 of the first demux switch element for implementing the first color and a first connection electrode DEMSD121 of the second demux switch element for implementing the first color may be disposed on the second interlayer insulating film 142. Also, a first connection electrode DEMSD112 of the first demux switch element for implementing the second color and a first connection electrode DEMSD113 of the first demux switch element for implementing the third color may be disposed on the second interlayer insulating film 142. The first connection electrode DEMSD112 of the first demux switch element for implementing the second color and the first connection electrode DEMSD113 of the first demux switch element for implementing the third color may be disposed between the first electrode of the first demux switch element and the first connection electrode DEMSD121 of the second demux switch element for implementing the first color.

The first connection electrode DEMSD111 of the first demux switch element for implementing the first color may pass through a first test contact hole TECT1 formed in the second interlayer insulating film 142. The first connection electrode DEMSD111 of the first demux switch element for implementing the first color may be connected to the fourth test connection line TECL4 exposed by the first test contact hole TECT1.

The first connection electrode DEMSD121 of the second demux switch element for implementing the first color may pass through a second test contact hole TECT2 formed in the second interlayer insulating film 142. The first connection electrode DEMSD121 of the second demux switch element for implementing the first color may be connected to a second test connection line TECL2 exposed by the second test contact hole TECT2.

The first data metal layer, which includes the first electrode of the first demux switch element, the first connection electrode DEMSD121 of the second demux switch element for implementing the first color, the first connection electrode DEMSD112 of the first demux switch element for implementing the second color, and the first connection electrode DEMSD113 of the first demux switch element for implementing the third color, may be disposed between the second interlayer insulating film 142 and the first planarization layer 160. The first planarization layer 160 may be disposed to cover the electrodes of the first data metal layer. The electrodes of the first data metal layer may include the same material as that of the first anode connection electrode ANDE1 described above.

The first power line PSL1 and the 21st data line DL21 may be disposed on the first planarization layer 160. The 21st data line DL21 may pass through the 21st data line contact hole DLCT21 formed in (e.g., penetrating) the first planarization layer 160. The 21st data line DL21 may be connected to the first connection electrode DEMSD121 of the second demux switch element for implementing the first color, which is exposed by the 21st data line contact hole DLCT21.

The first power line PSL1 may overlap with the first electrode of the first demux switch element, the first connection electrode DEMSD121 of the second demux switch element for implementing the first color, the first connection electrode DEMSD112 of the first demux switch element for implementing the second color, and the first connection electrode DEMSD113 of the first demux switch element for implementing the third color.

The first power line PSL1 may be connected to any one of a plurality of pads. The first power line PSL1 may receive a first power voltage of a driving circuit through a circuit board. In some embodiments, the display device may further include a second power line. The second power line may be connected to any one of the plurality of pads. The second power line may receive a second power voltage of the driving circuit through the circuit board. In this case, the first power voltage may be a voltage having a lower potential than that of the second power voltage. For example, the second power voltage may be a high potential driving voltage, and the first power voltage may be a low potential driving voltage.

The second data metal layer, which includes the first power line PSL1 and the 21st data line DL21, may be disposed between the first planarization layer 160 and the second planarization layer 180. The second planarization layer 180 may be disposed to cover the first power line PSL1 and the 21st data line DL21. The first power line PSL1 and the 21st data line DL21 may include the same material as that of the second anode connection electrode ANDE2 described above.

Referring to FIGS. 5A and 8, a first test active layer of the first test switch element TET1 may be disposed on the buffer film BF. The first test active layer may include a first electrode TESD11 of the first test switch element TET1, a second electrode TESD22 of the first test switch element TET1, and channels TEACT11 and TEACT12 of the first test switch element TET1, which are disposed between the first electrode TESD11 and the second electrode TESD22.

The first test active layer may include a silicon semiconductor, such as polycrystalline silicon, a single crystal silicon, a low-temperature polycrystalline silicon, and/or amorphous silicon. The first electrode TESD11 of the first test switch element TET1 and the second electrode TESD22 of the first test switch element TET1 may have a conductivity by doping the silicon semiconductor with ions or impurities. The first test active layer overlaps with the test gate electrode TEG in the third direction (e.g., the Z-axis direction), and the first electrode TESD11 of the first test switch element TET1 and the second electrode TESD22 of the first test switch element TET1 may not overlap with the test gate electrode TEG in the third direction (e.g., the Z-axis direction).

The first test switch element TET1 may include a plurality of transistors that are connected in series. The first test switch element TET1 may include an 11th test switch element TET11 and a 12th test switch element TET12. The 11th test switch element TET11 may include an 11th test active layer, and the 12th test switch element TET12 may include a 12th test active layer.

The 11th test active layer may include the first electrode TESD11 of the 11th test switch element TET11, a second electrode TESD12 of the 11th test switch element TET11, and a channel TEACT11 of the 11th test switch element TET11, which is disposed between the first electrode TESD11 and the second electrode TESD12.

The 11th test active layer may include a silicon semiconductor, such as polycrystalline silicon, a single crystal silicon, a low-temperature polycrystalline silicon, and/or amorphous silicon. The first electrode TESD11 of the 11th test switch element TET11 and the second electrode TESD12 of the 11th test switch element TET11 may have a conductivity by doping the silicon semiconductor with ions or impurities. The 11th test active layer overlaps with an 11th test gate electrode TEG11 in the third direction (e.g., the Z-axis direction), and the first electrode TESD11 of the 11th test switch element TET11 and the second electrode TESD12 of the 11th test switch element TET11 may not overlap the 11th test gate electrode TEG11 in the third direction (e.g., the Z-axis direction).

The 12th test active layer may include a first electrode TESD21 of the 12th test switch element TET12, the second electrode TESD22 of the 12th test switch element TET12, and a channel TEACT12 of the 12th test switch element TET12, which is disposed between these first and second electrodes TESD21 and TESD22.

The 12th test active layer may include a silicon semiconductor, such as polycrystalline silicon, a single crystal silicon, a low-temperature polycrystalline silicon, and/or amorphous silicon. The first electrode TESD21 of the 12th test switch element TET12 and the second electrode TESD22 of the 12th test switch element TET12 may have a conductivity by doping the silicon semiconductor with ions or impurities. The 12th test active layer overlaps with a 12th test gate electrode TEG12 in the third direction (e.g., the Z-axis direction), and the first electrode TESD21 of the 12th test switch element TET12 and the second electrode TESD22 of the 12th test switch element TET12 may not overlap with the 12th test gate electrode TEG12 in the third direction (e.g., the Z-axis direction).

When a plurality of transistors are connected in series, the second electrode TESD12 of the 11th test switch element TET11 may be connected to the first electrode TESD21 of the 12th test switch element TET12.

A functional layer, which includes the first test active layer, may be disposed between the buffer film BF and the gate insulating film 130. The gate insulating film 130 may be disposed to cover the first test active layer. The first test active layer may include the same material as that of the display active layer DACT described above.

The test gate electrode TEG may be disposed on the gate insulating film 130. The test gate electrode TEG may be formed as a plurality of test gate electrodes TEG. For example, the test gate electrode TEG may include the 11th test gate electrode TEG11 and the 12th test gate electrode TEG12.

A first gate metal layer, which includes the 11th test gate electrode TEG11 and the 12th test gate electrode TEG12, may be disposed between the gate insulating film 130 and the first interlayer insulating film 141. The first interlayer insulating film 141 may be disposed to cover the 11th test gate electrode TEG11 and the 12th test gate electrode TEG12. The 11th test gate electrode TEG11 and the 12th test gate electrode TEG12 may include the same material as that of the display gate electrode DG described above.

The first test connection line TECL1 and the second test connection line TECL2 may be disposed on the first interlayer insulating film 141. A second gate metal layer, which includes the first test connection line TECL1 and the second test connection line TECL2, may be disposed between the first interlayer insulating film 141 and the second interlayer insulating film 142. The second interlayer insulating film 142 may be disposed to cover the first test connection line TECL1 and the second test connection line TECL2. The first test connection line TECL1 and the second test connection line TECL2 may include the same material as that of the second capacitor electrode CAE2 described above.

The first test connection electrode TECE1 and the second test connection electrode TECE2 may be disposed on the second interlayer insulating film 142.

The first test connection electrode TECE1 may pass through an 11th test connection contact hole TETCT11 formed in (e.g., penetrating) the second interlayer insulating film 142. The first test connection electrode TECE1 may be connected to the first test connection line TECL1 exposed by the 11th test connection contact hole TETCT11.

The first test connection electrode TECE1 may pass through a 12th test connection contact hole TETCT12 formed in (e.g., penetrating) the second interlayer insulating film 142, the first interlayer insulating film 141, and the gate insulating film 130. The first test connection electrode TECE1 may be connected to the first test active layer exposed by the 12th test connection contact hole TETCT12.

The second test connection electrode TECE2 may pass through a 21st test connection contact hole TETCT21 formed in (e.g., penetrating) the second interlayer insulating film 142. The second test connection electrode TECE2 may be connected to the second test connection line TECL2 exposed by the 21st test connection contact hole TETCT21.

The second test connection electrode TECE2 may pass through a 22nd test connection contact hole TETCT22 formed in (e.g., penetrating) the second interlayer insulating film 142, the first interlayer insulating film 141, and the gate insulating film 130. The second test connection electrode TECE2 may be connected to the first test active layer exposed by the 22nd test connection contact hole TETCT22.

Referring to FIGS. 5A and 9, a second test active layer of the second test switch element TET2 may be disposed on the buffer film BF. The second test active layer may include a first electrode TESD13 of the second test switch element TET2, a second electrode TESD24 of the second test switch element TET2, and channels TEACT21 and TEACT22 of the second test switch element TET2, which are disposed between the first and second electrodes TESD13 and TESD24.

The second test active layer may include a silicon semiconductor, such as polycrystalline silicon, a single crystal silicon, a low-temperature polycrystalline silicon, and/or amorphous silicon. The first electrode TESD13 of the second test switch element TET2 and the second electrode TESD24 of the second test switch element TET2 may have a conductivity by doping the silicon semiconductor with ions or impurities. The second test active layer overlaps with the test gate electrode TEG in the third direction (e.g., the Z-axis direction), and the first electrode TESD13 of the second test switch element TET2 and the second electrode TESD24 of the second test switch element TET2 may not overlap with the test gate electrode TEG in the third direction (e.g., the Z-axis direction).

The second test switch element TET2 may include a plurality of transistors connected in series. The second test switch element TET2 may include a 21st test switch element TET21 and a 22nd test switch element TET22. The 21st test switch element TET21 may include an 11th test active layer, and the 22nd test switch element TET22 may include a 12th test active layer.

The 11th test active layer may include the first electrode TESD13 of the 21st test switch element TET21, a second electrode TESD14 of the 21st test switch element TET21, and a channel TEACT21 of the 21st test switch element TET21, which is disposed between the first and second electrodes TESD13 and TESD14.

The 11th test active layer may include a silicon semiconductor, such as polycrystalline silicon, a single crystal silicon, a low-temperature polycrystalline silicon, and/or amorphous silicon. The first electrode TESD13 of the 21st test switch element TET21 and the second electrode TESD14 of the 21st test switch element TET21 may have a conductivity by doping the silicon semiconductor with ions or impurities. The 11th test active layer overlaps with a 21st test gate electrode TEG21 in the third direction (e.g., the Z-axis direction), and the first electrode TESD13 of the 21st test switch element TET21 and the second electrode TESD14 of the 21st test switch element TET21 may not overlap with the 21st test gate electrode TEG21 in the third direction (e.g., the Z-axis direction).

The 12th test active layer may include a first electrode TESD23 of the 22nd test switch element TET22, the second electrode TESD24 of the 22nd test switch element TET22, and a channel TEACT22 of the 12th test switch element TET12, which is disposed between the first and second electrodes TESD23 and TESD24.

The 12th test active layer may include a silicon semiconductor, such as polycrystalline silicon, a single crystal silicon, a low-temperature polycrystalline silicon, and/or amorphous silicon. The first electrode TESD23 of the 22nd test switch element TET22 and the second electrode TESD24 of the 22nd test switch element TET22 may have a conductivity by doping the silicon semiconductor with ions or impurities. The 12th test active layer overlaps with a 22nd test gate electrode TEG22 in the third direction (e.g., the Z-axis direction), and the first electrode TESD23 of the 22nd test switch element TET22 and the second electrode TESD24 of the 22nd test switch element TET22 may not overlap with the 22nd test gate electrode TEG22 in the third direction (e.g., the Z-axis direction).

When a plurality of transistors are connected in series, the second electrode TESD21 of the 21st test switch element TET21 may be connected to the first electrode TESD23 of the 22nd test switch element TET22.

A functional layer, which includes the second test active layer, may be disposed between the buffer film BF and the gate insulating film 130. The gate insulating film 130 may be disposed to cover the second test active layer. The second test active layer may include the same material as that of the display active layer DACT described above.

The third test connection line TECL3 and the test gate electrode TEG may be disposed on the gate insulating film 130. The test gate electrode TEG may be formed as a plurality of test gate electrodes TEG. For example, the test gate electrode TEG may include the 21st test gate electrode TEG21 and the 22nd test gate electrode TEG22.

A first gate metal layer, which includes the third test connection line TECL3, the 21st test gate electrode TEG21, and the 22nd test gate electrode TEG22, may be disposed between the gate insulating film 130 and the first interlayer insulating film 141. The first interlayer insulating film 141 may be disposed to cover the third test connection line TECL3, the 21st test gate electrode TEG21, and the 22nd test gate electrode TEG22. The third test connection line TECL3, the 21st test gate electrode TEG21, and the 22nd test gate electrode TEG22 may include the same material as that of the display gate electrode DG described above.

The fourth test connection line TECL4 may be disposed on the first interlayer insulating film 141. A second gate metal layer, which includes the fourth test connection line TECL4, may be disposed between the first interlayer insulating film 141 and the second interlayer insulating film 142. The second interlayer insulating film 142 may be disposed to cover the fourth test connection line TECL4. The fourth test connection line TECL4 may include the same material as that of the second capacitor electrode CAE2 described above.

The third test connection electrode TECE3 and the fourth test connection electrode TECE4 may be disposed on the second interlayer insulating film 142.

The third test connection electrode TECE3 may pass through a 31st test connection contact hole TETCT31 formed in (e.g., penetrating) the second interlayer insulating film 142 and the first interlayer insulating film 141. The third test connection electrode TECE3 may be connected to the third test connection line TECL3 exposed by the 31st test connection contact hole TETCT31.

The third test connection electrode TECE3 may pass through a 32nd test connection contact hole TETCT32 formed in (e.g., penetrating) the second interlayer insulating film 142, the first interlayer insulating film 141, and the gate insulating film 130. The third test connection electrode TECE3 may be connected to the second test active layer exposed by the 32nd test connection contact hole TETCT32.

The fourth test connection electrode TECE4 may pass through a 41st test connection contact hole TETCT41 formed in (e.g., penetrating) the second interlayer insulating film 142. The fourth test connection electrode TECE4 may be connected to the fourth test connection line TECL4 exposed by the 41st test connection contact hole TETCT41.

The fourth test connection electrode TECE4 may pass through a 42nd test connection contact hole TETCT42 formed in (e.g., penetrating) the second interlayer insulating film 142, the first interlayer insulating film 141, and the gate insulating film 130. The fourth test connection electrode TECE4 may be connected to the second test active layer exposed by the 42nd test connection contact hole TETCT42.

Referring to FIGS. 8 and 9, the first test connection line TECL1, the second test connection line TECL2, and the fourth test connection line TECL4 may all be formed on the first interlayer insulating film 141. The third test connection line TECL3 may be formed on the gate insulating film 130.

In an embodiment, the second test connection line TECL2 may be formed at (e.g., in or on) the same layer as that of the fourth test connection line TECL4, and the first test connection line TECL1 may be formed at (e.g., in or on) a different layer from that of the third test connection line TECL3. A path for transmitting the data voltage output from the demux switch element to the test switch element is the second test connection line TECL2 and the fourth test connection line TECL4, which may be formed of the same material as each other to improve a test accuracy, reduce a skew value deviation, and the like. As illustrated in the plan view described above, the first test connection line TECL1 and the third test connection line TECL3 may be formed of different materials from each other for advantages in designing and arranging the lines.

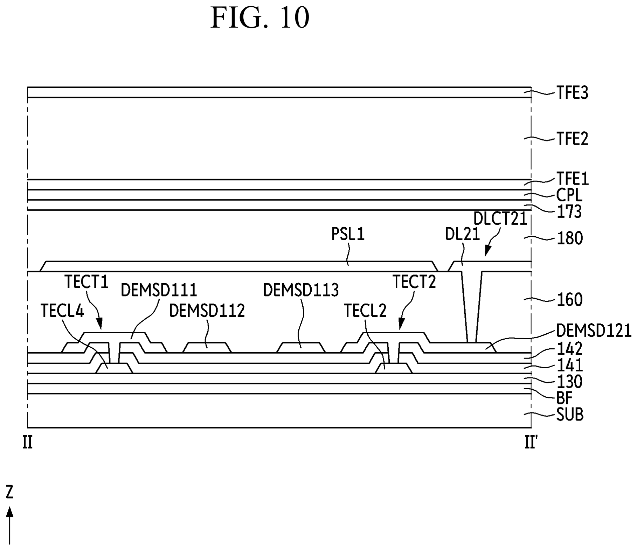

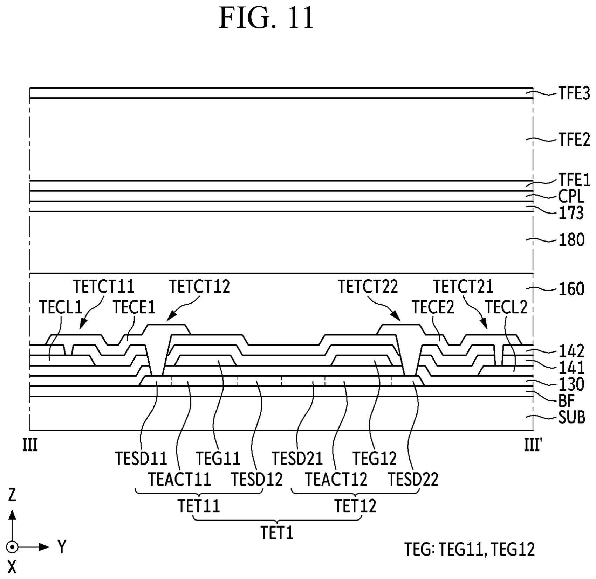

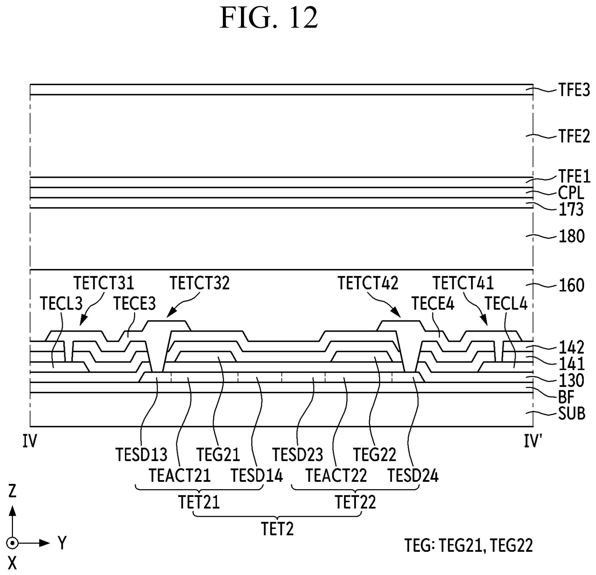

FIG. 10 is a cross-sectional view taken along the line II-II' of FIG. 5A in a display device according to an embodiment of the present disclosure. FIG. 11 is a cross-sectional view taken along the line III-III' of FIG. 5A in a display device according to an embodiment of the present disclosure. FIG. 12 is a cross-sectional view taken along the line IV-IV' of FIG. 5A in a display device according to an embodiment of the present disclosure. In FIGS. 10 to 12, the same reference numerals are used to denote the same or substantially the same elements as those described above, and thus, redundant description thereof may not be repeated hereinafter.

The embodiments illustrated in FIGS. 10 to 12 may be different from the embodiments described above with reference to FIGS. 7 to 9, in that the second test connection line TECL2, the third test connection line TECL3, and the fourth test connection line TECL4 may be formed on the gate insulating film 130, and the first test connection line TECL1 may be formed on the first interlayer insulating film 141. On the other hand, in the embodiments described above with reference to FIGS. 7 to 9, the first test connection line TECL1, the second test connection line TECL2, and the fourth test connection line TECL4 may be formed on the first interlayer insulating film 141, and the third test connection line TECL3 may be formed on the gate insulating film 130.

Referring to FIGS. 5A and 10, the second test connection line TECL2 and the fourth test connection line TECL4 may be disposed on the gate insulating film 130. A first gate metal layer, which includes the second test connection line TECL2 and the fourth test connection line TECL4, may be disposed between the gate insulating film 130 and the first interlayer insulating film 141. The first interlayer insulating film 141 may be disposed to cover the second test connection line TECL2 and the fourth test connection line TECL4. The second test connection line TECL2 and the fourth test connection line TECL4 may include the same material as that of the display gate electrode DG described above.

The first connection electrode DEMSD111 of the first demux switch element for implementing the first color may pass through the first test contact hole TECT1 formed in (e.g., penetrating) the first interlayer insulating film 141 and the second interlayer insulating film 142.

The first connection electrode DEMSD121 of the second demux switch element for implementing the first color may pass through the second test contact hole TECT2 formed in (e.g., penetrating) the first interlayer insulating film 141 and the second interlayer insulating film 142.

Referring to FIGS. 5A and 11, the test gate electrode TEG and the second test connection line TECL2 may be disposed on the gate insulating film 130.

A first gate metal layer, which includes the 11th test gate electrode TEG11, the 12th test gate electrode TEG12, and the second test connection line TECL2, may be disposed between the gate insulating film 130 and the first interlayer insulating film 141. The first interlayer insulating film 141 may be disposed to cover the 11th test gate electrode TEG11, the 12th test gate electrode TEG12, and the second test connection line TECL2. The 11th test gate electrode TEG11, the 12th test gate electrode TEG12, and the second test connection line TECL2 may include the same material as that of the display gate electrode DG described above.

The first test connection line TECL1 may be disposed on the first interlayer insulating film 141.

The first test connection electrode TECE1 and the second test connection electrode TECE2 may be disposed on the second interlayer insulating film 142.

The second test connection electrode TECE2 may pass through the 21st test connection contact hole TETCT21 formed in (e.g., penetrating) the second interlayer insulating film 142 and the first interlayer insulating film 141. The second test connection electrode TECE2 may be connected to the second test connection line TECL2 exposed by the 21st test connection contact hole TETCT21.

Referring to FIGS. 5A and 12, the third test connection line TECL3, the fourth test connection line TECL4, and the test gate electrode TEG may be disposed on the gate insulating film 130.

A first gate metal layer, which includes the third test connection line TECL3, the fourth test connection line TECL4, the 21st test gate electrode TEG21 and the 22nd test gate electrode TEG22, may be disposed between the gate insulating film 130 and the first interlayer insulating film 141. The first interlayer insulating film 141 may be disposed to cover the third test connection line TECL3, the fourth test connection line TECL4, the 21st test gate electrode TEG21, and the 22nd test gate electrode TEG22. The third test connection line TECL3, the fourth test connection line TECL4, the 21st test gate electrode TEG21, and the 22nd test gate electrode TEG22 may include the same material as that of the display gate electrode DG described above.

The third test connection electrode TECE3 and the fourth test connection electrode TECE4 may be disposed on the second interlayer insulating film 142.

The fourth test connection electrode TECE4 may pass through the 41st test connection contact hole TETCT41 formed in (e.g., penetrating) the second interlayer insulating film 142 and the first interlayer insulating film 141.

Referring to FIGS. 11 and 12, the second test connection line TECL2, the third test connection line TECL3, and the fourth test connection line TECL4 may be all formed on the gate insulating film 130. The first test connection line TECL1 may be formed on the first interlayer insulating film 141.

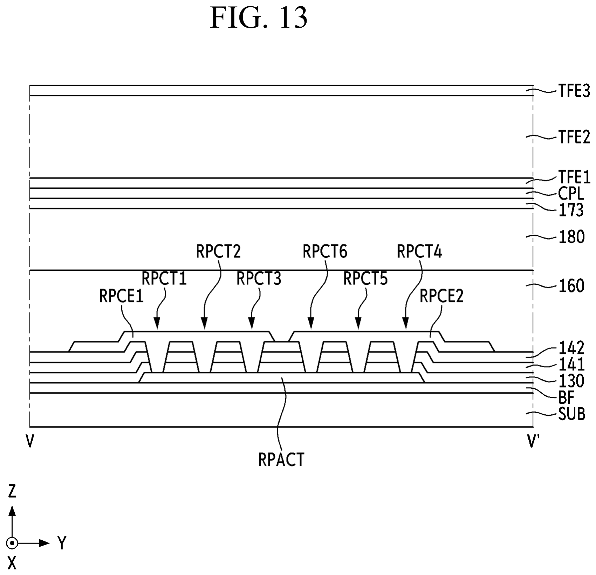

FIG. 13 is a cross-sectional view taken along the line V-V' of FIG. 5A in a display device according to an embodiment of the present disclosure.

Referring to FIGS. 5A and 13, the resistance active layer RPACT may be formed on the buffer film BF. At least a portion of the resistance active layer RPACT may overlap with the first resistance connection electrode RPCE1 and the second resistance connection electrode RPCE2. A functional layer, which includes the resistance active layer RPACT, may be disposed between the buffer film BF and the gate insulating film 130. The gate insulating film 130 may be disposed to cover the resistance active layer RPACT. The resistance active layer RPACT may include the same material as that of the display active layer DACT described above, but the present disclosure is not limited thereto.

The first resistance connection electrode RPCE1 and the second resistance connection electrode RPCE2 may be disposed on the second interlayer insulating film 142. The first resistance connection electrode RPCE1 may pass through first group resistance contact holes RPCT1, RPCT2, and RPCT3 formed in (e.g., penetrating) the first interlayer insulating film 141, the second interlayer insulating film 142, and the gate insulating film 130. The first resistance connection electrode RPCE1 may be connected to the resistance active layer RPACT exposed by the first group resistance contact holes RPCT1, RPCT2, and RPCT3.

The second resistance connection electrode RPCE2 may pass through second group resistance contact holes RPCT4, RPCT5, and RPCT6 formed in (e.g., penetrating) the first interlayer insulating film 141, the second interlayer insulating film 142, and the gate insulating film 130. The second resistance connection electrode RPCE2 may be connected to the resistance active layer RPACT exposed by the second group resistance contact holes RPCT4, RPCT5, and RPCT6.

The first group resistance contact holes RPCT1, RPCT2, and RPCT3 and the second group resistance contact holes RPCT4, RPCT5, and RPCT6 may respectively include a plurality of resistance contact holes, and the number of contact holes included in the first group resistance contact holes RPCT1, RPCT2, and RPCT3 may be the same as the number of contact holes included in the second group resistance contact holes RPCT4, RPCT5, and RPCT6. As the plurality of contact holes are formed, a signal from the test gate pad TGP may be more smoothly transferred to the test switch element, despite a high resistance of the resistance active layer RPACT. Also, as the number of contact holes included in the first group resistance contact holes RPCT1, RPCT2, and RPCT3 is the same as the number of contact holes included in the second group resistance contact holes RPCT4, RPCT5, and RPCT6, an electrostatic discharge function performed by the resistance active layer RPACT may be uniformly performed on both sides, and reliability of the display device may be improved.

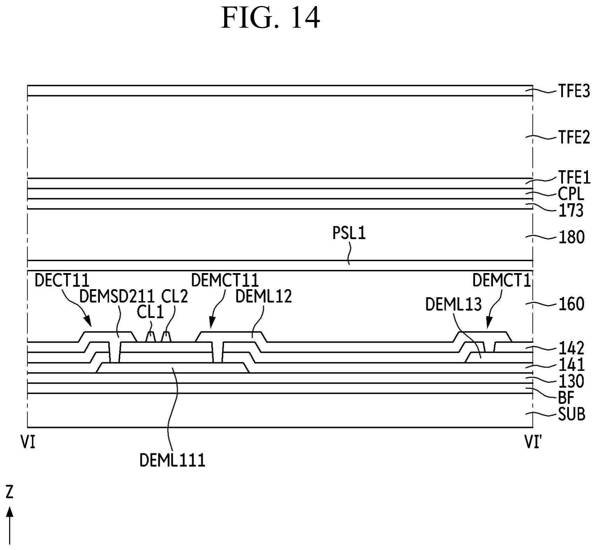

FIG. 14 is a cross-sectional view taken along the line VI-VI' of FIG. 5A in a display device according to an embodiment of the present disclosure.

Referring to FIGS. 5A and 14, the 111th demux connection line DEML111 may be disposed on the gate insulating film 130. A first gate metal layer, which includes the 111th demux connection line DEML111, may be disposed between the gate insulating film 130 and the first interlayer insulating film 141. The first interlayer insulating film 141 may be disposed to cover the 111th demux connection line DEML111. The 111th demux connection line DEML111 may include the same material as that of the display gate electrode DG described above.

The 13th demux connection line DEML13 may be disposed on the first interlayer insulating film 141. A second gate metal layer, which includes the 13th demux connection line DEML13, may be disposed between the first interlayer insulating film 141 and the second interlayer insulating film 142. The second interlayer insulating film 142 may be disposed to cover the 13th demux connection line DEML13. The 13th demux connection line DEML13 may include the same material as that of the second capacitor electrode CAE2 described above.

The second connection electrode DEMSD211 of the first demux switch element for implementing the first color and the 12th demux connection line DEML12 may be disposed on the second interlayer insulating film 142. The first clock line CL1 and the second clock line CL2 may be disposed on the second interlayer insulating film 142. The first clock line CL1 and the second clock line CL2 may be sequentially disposed between the second connection electrode DEMSD211 of the first demux switch element for implementing the first color and the 12th demux connection line DEML12.

The second connection electrode DEMSD211 of the first demux switch element for implementing the first color may pass through the 11th demux contact hole DECT11 formed in (e.g., penetrating) the second interlayer insulating film 142 and the first interlayer insulating film 141. The second connection electrode DEMSD211 of the first demux switch element for implementing the first color may be connected to the 111th demux connection line DEML111 exposed by the 11th demux contact hole DECT11.

The 12th demux connection line DEML12 may pass through the 11th demux connection contact hole DEMCT11 formed in (e.g., penetrating) the second interlayer insulating film 142 and the first interlayer insulating film 141. The 12th demux connection line DEML12 may be connected to the 111th demux connection line DEML111 exposed by the 11th demux connection contact hole DEMCT11.

The 12th demux connection line DEML12 may pass through the first demux connection contact hole DEMCT1 formed in (e.g., penetrating) the second interlayer insulating film 142. The 12th demux connection line DEML12 may be connected to the 13th demux connection line DEML13 exposed by the first demux connection contact hole DEMCT1.

A first data metal layer, which includes the second connection electrode DEMSD211 of the first demux switch element for implementing the first color and the 12th demux connection line DEML12, may be disposed between the second interlayer insulating film 142 and the first planarization layer 160. The first planarization layer 160 may be disposed to cover the second connection electrode DEMSD211 and the 12th demux connection line DEML12. The second connection electrode DEMSD211 of the first demux switch element for implementing the first color and the 12th demux connection line DEML12 include the same material as that of the first anode connection electrode ANDE1 described above.

The first power line PSL1 may be disposed on the first planarization layer 160. The first power line PSL1 may overlap with the second connection electrode DEMSD211 of the first demux switch element for implementing the first color, the 12th demux connection line DEML12, the first clock line CL1, the second clock line CL2, and the 111th demux connection line DEML111. A second data metal layer, which includes the first power line PSL1, may be disposed between the first planarization layer 160 and the second planarization layer 180. The second planarization layer 180 may be disposed to cover the first power line PSL1. The first power line PSL1 may include the same material as that of the second anode connection electrode ANDE2 described above.

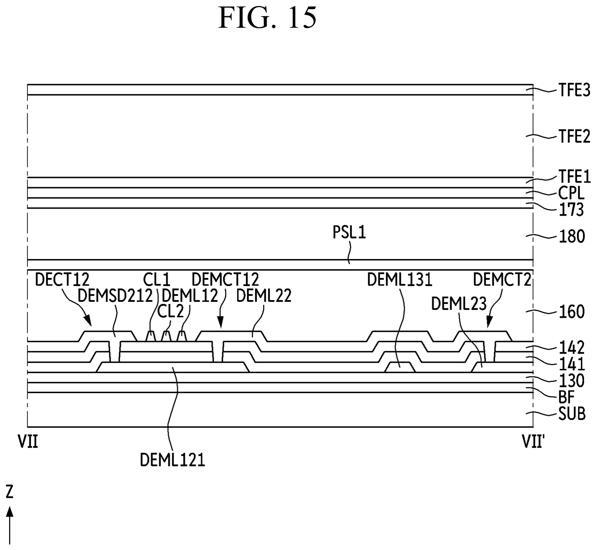

FIG. 15 is a cross-sectional view taken along the line VII-VII' of FIG. 5A in a display device according to an embodiment of the present disclosure.

Referring to FIGS. 5A and 15, the 121st demux connection line DEML121 and the 23rd demux connection line DEML23 may be disposed on the gate insulating film 130. The second connection electrode DEMSD213 of the first demux switch element for implementing the third color may be disposed on the gate insulating film 130. The second connection electrode DEMSD213 of the first demux switch element for implementing the third color may be disposed between the 121st demux connection line DEML121 and the 23rd demux connection line DEML23.

A first gate metal layer, which includes the 121st demux connection line DEML121, the 23rd demux connection line DEML23, and the second connection electrode DEMSD213 of the first demux switch element for implementing the third color, may be disposed between the gate insulating film 130 and the first interlayer insulating film 141. The first interlayer insulating film 141 may be disposed to cover the gate insulating film 130 and the first interlayer insulating film 141. The 121st demux connection line DEML121, the 23rd demux connection line DEML23, and the second connection electrode DEMSD213 of the first demux switch element for implementing the third color may include the same material as that of the display gate electrode DG described above.

The second connection electrode DEMSD212 of the first demux switch element for implementing the second color and the 22nd demux connection line DEML22 may be disposed on the second interlayer insulating film 142. The first clock line CL1, the second clock line CL2, and the 12th demux connection line DEML12 may be sequentially disposed between the second connection electrode DEMSD212 and the 22nd demux connection line DEML22.

The second connection electrode DEMSD212 of the first demux switch element for implementing the second color may pass through the 12th demux contact hole DECT12 formed in (e.g., penetrating) the first interlayer insulating film 141 and the second interlayer insulating film 142. The second connection electrode DEMSD212 of the first demux switch element for implementing the second color may be connected to the 121st demux connection line DEML121 exposed by the 12th demux contact hole DECT12.

The 22nd demux connection line DEML22 may pass through the 12th demux connection contact hole DEMCT12 formed in (e.g., penetrating) the first interlayer insulating film 141 and the second interlayer insulating film 142. The 22nd demux connection line DEML22 may be connected to the 121st demux connection line DEML121 exposed by the 12th demux connection contact hole DEMCT12.

The 22nd demux connection line DEML22 may pass through the second demux connection contact hole DEMCT2 formed in (e.g., penetrating) the first interlayer insulating film 141 and the second interlayer insulating film 142. The 22nd demux connection line DEML22 may be connected to the 23rd demux connection line DEML23 exposed by the second demux connection contact hole DEMCT2.

A first data metal layer, which includes the second connection electrode DEMSD212 of the first demux switch element for implementing the second color, the 22nd demux connection line DEML22, the 12th demux connection line DEML12, the first clock line CL1, and the second clock line CL2, may be disposed between the second interlayer insulating film 142 and the first planarization layer 160. The first planarization layer 160 may be disposed to cover the second connection electrode DEMSD212 of the first demux switch element for implementing the second color, the 22nd demux connection line DEML22, the 12th demux connection line DEML12, the first clock line CL1, and the second clock line CL2. The second connection electrode DEMSD212 of the first demux switch element for implementing the second color, the 22nd demux connection line DEML22, the 12th demux connection line DEML12, the first clock line CL1, and the second clock line CL2 may include the same material as that of the first anode connection electrode ANDE1 described above.

The first power line PSL1 may be disposed on the first planarization layer 160. The first power line PSL1 may overlap with the second connection electrode DEMSD212 of the first demux switch element for implementing the second color, the 22nd demux connection line DEML22, the 12th demux connection line DEML12, the first clock line CL1, the second clock line CL2, the 121st demux connection line DEML121, the 131st demux connection line DEML131, and the 23rd demux connection line DEML23.

A second data metal layer, which includes the first power line PSL1, may be disposed between the first planarization layer 160 and the second planarization layer 180. The second planarization layer 180 may be disposed to cover the first power line PSL1. The first power line PSL1 may include the same material as that of the second anode connection electrode ANDE2 described above.

Referring to FIGS. 5D, 14, and 15, at least one (e.g., DEML13) of the plurality of demux connection lines DEML111, DEML12, and DEML13, which connect the first data pad to the first group demux switch element, may be disposed on a different layer from that of at least one (e.g., DEML23) of the plurality of demux connection lines DEML121, DEML22, and DEML23, which connect the second data pad to the first group demux switch element. At least one (e.g., DEML23) of the plurality of demux connection lines DEML121, DEML22, and DEML23, which connect the second data pad to the first group demux switch element, may be disposed on a different layer from that of at least one (e.g., DEML33) of the plurality of demux connection lines DEML131, DEML32, and DEML33, which connect the third data pad to the first group demux switch element.

The 13th demux connection line DEML13 and the 23rd demux connection line DEML23 may be disposed on layers different from each other. The 23rd demux connection line DEML23 and the 33rd demux connection line DEML33 may be disposed on layers different from each other. The 13th demux connection line DEML13 and the 33rd demux connection line DEML33 may be disposed on the same layer as each other. As the layers of the demux connection lines are disposed as described above, the lines may be more easily arranged, and an effective design area may be provided. This multi-layer arrangement allows for a more compact layout in the non-display area by enabling conductive paths to cross without making electrical contact. This prevents signal crosstalk between adjacent data paths and simplifies the routing of the connections, which is advantageous for high-resolution displays where space in the peripheral circuit area is limited. This improves the overall manufacturing yield and electronic performance of the device.

The display device according to some embodiments of the present disclosure may be applied to various suitable electronic devices. The electronic devices according to an embodiment includes the above-described display device, and may further include a module or device, which has other additional functions in addition to that of the display device.

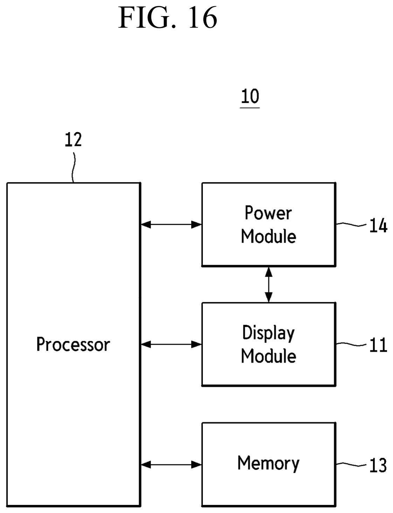

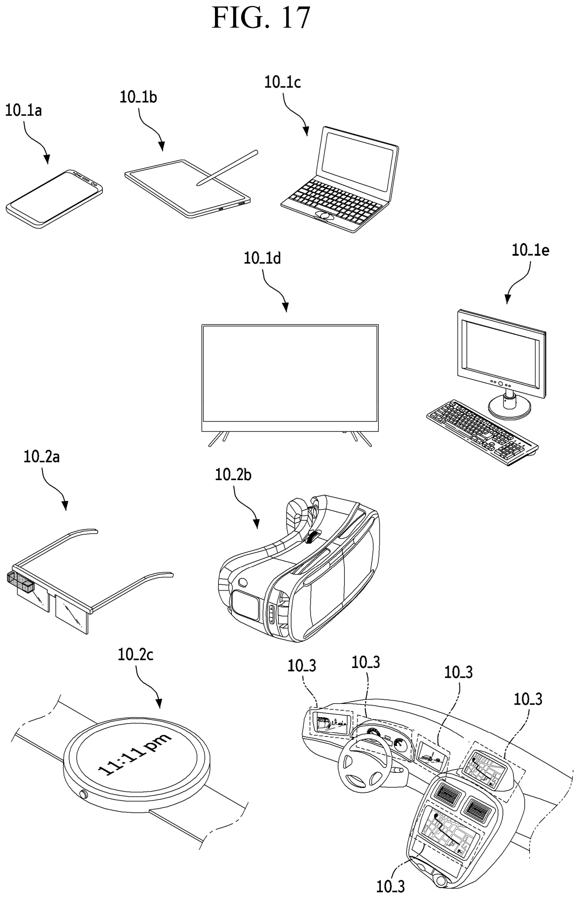

FIG. 16 is a block diagram of an electronic device according to an embodiment of the present disclosure. FIG. 17 illustrates schematic views of an electronic device according to some embodiments of the present disclosure.

Referring to FIG. 16, an electronic device 10 according to an embodiment may include a display module 11, a processor 12, a memory 13, and a power module 14.

The processor 12 may include at least one of a central processing unit (CPU), an application processor (AP), a graphic processing unit (GPU), a communication processor (CP), an image signal processor (ISP), or a controller.

The memory 13 may store data information required for an operation of the processor 12 or the display module 11. When the processor 12 executes an application stored in the memory 13, an image data signal and/or an input control signal is transferred to the display module 11, and the display module 11 may output image information through a display screen by processing the received signal.

The power module 14 may include a power supply module such as a power adapter or a battery device. The power module 14 may include a power conversion module. The power conversion module may convert power supplied by the power supply module to generate power required for the operation of the electronic device 10.

At least one of the respective components of the electronic device 10 may be included in the display device according to the above-described embodiments. In addition, some of the individual modules functionally included in one module may be included in the display device, and others may be provided separately from the display device. For example, the display device includes the display module 11, and the processor 12, the memory 13 and the power module 14 may be provided in the form of another device in the electronic device other than the display device.

Referring to FIG. 17, various electronic devices to which the display device according to the embodiments of the present disclosure is applied may include an electronic device for displaying an image, such as a smartphone 10_1a, a tablet PC 10_1b, a laptop 10_1c, a TV 10_1d, and a desk monitor 10_1e. In addition, various electronic devices to which the display device according to the embodiments of the present disclosure is applied may include a wearable electronic device including a display module such as a smart glasses 10_2a, a head mounted display 10_2b and a smart watch 10_2c, and a vehicle electronic device 10_3 including a display module such as a vehicle dashboard, a center fascia, a center information display (CID) disposed on the dashboard, and a room mirror display.

The foregoing is illustrative of some embodiments of the present disclosure, and is not to be construed as limiting thereof. Although some embodiments have been described, those skilled in the art will readily appreciate that various modifications are possible in the embodiments without departing from the scope of the present disclosure. It will be understood that descriptions of features or aspects within each embodiment should typically be considered as available for other similar features or aspects in other embodiments, unless otherwise described. Thus, as would be apparent to one of ordinary skill in the art, features, characteristics, and/or elements described in connection with a particular embodiment may be used singly or in combination with features, characteristics, and/or elements described in connection with other embodiments unless otherwise specifically indicated.

## Claims

1. A display device (10) comprising:
a plurality of subpixels (SP11, SP12, SP13, SP21, SP22, SP23);
a plurality of data lines (DL11, DL12, DL13, DL21, DL22, DL23) electrically connected to the plurality of subpixels (SP11, SP12, SP13, SP21, SP22, SP23);
a plurality of data pads (DP1, DP2, DP3) electrically connected to the plurality of data lines (DL11, DL12, DL13, DL21, DL22, DL23);
a plurality of test pads (TP1, TP2) comprising a first test pad (TP1) and a second test pad (TP2), the first test pad (TP1) and the second test pad (TP2) being spaced from the plurality of data pads (DP1, DP2, DP3);
a first group demux switch element (GDEMT1) connecting a first group data line of the plurality of data lines (DL11, DL12, DL13, DL21, DL22, DL23) to the plurality of data pads (DP1, DP2, DP3);
a second group demux switch element (GDEMT2) connecting a second group data line of the plurality of data lines (DL11, DL12, DL13, DL21, DL22, DL23) to the plurality of data pads (DP1, DP2, DP3); and
a first test switch element (TET1) located between a first electrode (DEMSD111) of only a selected one of a plurality of first demux switch elements (DEMT1) included in the first group demux switch element (GDEMT1) and the first test pad (TP1).

2. The display device (10) of claim 1, further comprising:
a second test switch element (TET2) located between a first electrode (DEMSD121) of only a selected one of a plurality ofsecond demux switch elements included in the second group demux switch element (GDEMT2) and the second test pad (TP2), wherein other second demux switch elements, except for the selected one of the second demux switch elements are electrically separated from the second test switch element (TET2); and/or
a resistor (RP) connected to a gate electrode of the first test switch element (TET1) and a gate electrode of the second test switch element (TET2); and/or
an electrostatic discharge circuit (EDC) electrically connected to the plurality of data pads (DP1, DP2, DP3), the plurality of test pads (TP1, TP2), and the resistor (RP).

3. The display device (10) of claim 2, wherein the first group demux switch element (GDEMT1) and/or the second group demux switch element (GDEMT2) comprises a plurality of transistors (DEMT11, DEMT12, DEMT13, DEMT14) connected in parallel with each other, and/or
wherein the first test switch element (TET1) and/or the second test switch element (TET2) comprises a plurality of transistors (TET11, TET12; TET21, TET22) connected in series with each other.

4. The display device of claim 3, wherein the plurality of subpixels comprises:
a first group subpixel connected to the first group demux switch element through the first group data line; and
a second group subpixel connected to the second group demux switch element through the second group data line,
wherein a selected one of a plurality of first subpixels (SP11) included in the first group subpixel (GSP1) implements a first color, and is connected to the selected one of the first demux switch elements (DEMT1), and
wherein a selected one of a plurality of second subpixels (SP21) included in the second group subpixel (GSP2) implements the first color, and is connected to the selected one of the second demux switch elements.

5. The display device (10) of claim **4,** wherein the selected one of the plurality of the first subpixels (SP11) is connected to the first electrode (DEMSD111) of the selected one of the first demux switch elements (DEMT1), and
wherein the selected one of the plurality of second subpixels (SP21) is connected to the first electrode (DEMSD121) of the selected one of the second demux switch elements.

6. The display device (10) of claim 2, further comprising a resistance active layer (RPACT),
wherein the first test switch element (TET1) comprises a first test active layer, and a first test gate electrode (TEG11) located on a gate insulating film (130) covering the first test active layer,
wherein the resistance active layer (RPACT) is electrically connected to the gate electrode (TEG) of the first test switch element (TET1), and
wherein the first test active layer comprises:
a first electrode (TESD22) connected to the first electrode (DEMSD111) of the selected one of the first demux switch elements (DEMT1);
a second electrode (TESD11) connected to the first test pad (TP1); and
a channel (TEACT11, TEACT12) located between the first electrode (TESD22) of the first test active layer and the second electrode (TESD11) of the first test active layer.

7. The display device (10) of claim 6, wherein the first test active layer and the resistance active layer (RPACT) are located at a same layer as each other.

8. The display device (10) of claim 2, wherein a first electrode (TESD22) of the first test switch element (TET1) is connected to the first electrode (DEMSD121) of the selected one of the first demux switch elements (DEMT1) through a second test connection line (TECL2),
wherein a second electrode (TESD11) of the first test switch element (TET1) is connected to the first test pad (TP1) through a first test connection line (TECL1),
wherein a first electrode (TESD24) of the second test switch element (TET2) is connected to the first electrode (DEMSD111) of the selected one of the second demux switch elements through a fourth test connection line (TECL4),
wherein a second electrode (TESD13) of the second test switch element (TET2) is connected to the second test pad (TP2) through a third test connection line (TECL3),
wherein the second test connection line (TECL2) and the fourth test connection line (TECL4) are located at a same layer as each other, and
wherein the first test connection line (TECL1) and the third test connection line (TECL3) are located on different layers from each other.

9. The display device (10) of claim 6, wherein a resistance of the resistance active layer (RPACT) is 1000Ω or more and 10000Ω or less.

10. An electronic device (10_1a, 10_1b, 10_1c, 10_1d, 10_1e, 10_2a, 10_2b, 10_2c, 10_3) comprising:
a display module (11) configured to display an image;
a power supply module (14) configured to supply a power source to the display module (11); and
a processor (12) configured to transmit a data signal and a control signal to the display module (11),
wherein the display module (11) is a display device (10) according to any one of claims 1 to 9.

11. The electronic device of claim 10, wherein the display device (10) further comprises a first power line (PSL1) configured to be applied with a first power voltage,
wherein the first power line (PSL1) is spaced from the first test switch element (TET1) in a plan view.

12. The electronic device of claim 11, wherein the first power line (PSL1) is spaced from the resistance active layer (RPACT) in a plan view, and
wherein the first power line (PSL1) overlaps with the first group demux switch element (GDEMT1) and the second group demux switch element (GDEMT2) in a plan view.

13. The electronic device of claim 10, wherein the display device (10) comprises a resistance active layer (RPACT) and further comprises:
a first resistance connection electrode (RPCE1) connected to the resistance active layer (RPACT) through a plurality of first group resistance contact holes (RPCT1, RPCT2, RPCT3); and
a second resistance connection electrode (RPCE2) connected to the resistance active layer (RPACT) through a plurality of second group resistance contact holes (RPCT4, RPCT5, RPCT6).

14. The electronic device of claim 13, wherein a number of the plurality of first group resistance contact holes (RPCT1, RPCT2, RPCT3) connecting the first resistance connection electrode (RPCE1) with the resistance active layer (RPACT) is the same as a number of the plurality of second group resistance contact holes (RPCT4, RPCT5, RPCT6) connecting the second resistance connection electrode (RPCE2) with the resistance active layer (RPACT).

15. The electronic device of claim 10, wherein the plurality of data pads (DP1, DP2, DP3) comprises a first data pad (DP1) and a second data pad (DP2), and
wherein at least one of a plurality of demux connection lines (DEML13) connecting the first data pad (DP1) to the first group demux switch element (GDEMT1) is located on a layer different from that of at least one of a plurality of demux connection lines (DEML23) connecting the second data pad (DP2) to the first group demux switch element (GDEMT1).
